# EUROPEAN PATENT APPLICATION

(11) **EP 4 783 776 A2**
(43) Date of publication of application: **29.07.2026**
(21) Application number: 26153369.9
(22) Date of filing: 22.01.2026
(51) Int. Cl.: H10F 10/16, H10F 19/31, H10F 77/12, H10F 77/20

(54) **SOLAR CELL MODULE**

(30) Priority: 23.01.2025 JP 2025009580
(71) Applicant: KABUSHIKI KAISHA TOSHIBA, Kawasaki-shi, Kanagawa 212-0013 (JP); Toshiba Energy Systems & Solutions Corporation, Kawasaki-shi, Kanagawa 212-0013 (JP)
(72) Inventor: YAMAMOTO, Kazushige, Kawasaki-shi, Kanagawa (JP); WADA, Atsushi, Kawasaki-shi, Kanagawa (JP); YOSHIO, Sara, Kawasaki-shi, Kanagawa (JP); SHIBASAKI, Soichiro, Kawasaki-shi, Kanagawa (JP); YAMAMOTO, Takashi, Kawasaki-shi, Kanagawa (JP); MIZUNO, Yukitami, Kawasaki-shi, Kanagawa (JP); NAKAGAWA, Naoyuki, Kawasaki-shi, Kanagawa (JP); TOYOTA, Motohiro, Kawasaki-shi, Kanagawa (JP); HONISHI, Yuya, Kawasaki-shi, Kanagawa (JP); SANO, Junji, Kawasaki-shi, Kanagawa (JP); SUGIMOTO, Kanta, Kawasaki-shi, Kanagawa (JP)
(74) Representative: Hoffmann Eitle

(57) **Abstract**

A solar cell module according to an embodiment comprises a substrate; a first solar cell provided on the substrate; a first solar cell including a first upper transparent electrode layer, a first power generation layer, and a first lower transparent electrode layer; a second solar cell provided on the substrate, adjacent to the first solar cell, the second solar cell including a second upper transparent electrode layer, a second power generation layer, and a second lower transparent electrode layer; and a first metal interconnection wiring that electrically connects the first solar cell and the second solar cell. The first upper transparent electrode layer and the second upper transparent electrode layer are provided on the light incident side, and the first solar cell and the second solar cell are arranged in a first direction extending along the width direction of the first solar cell. The first lower transparent electrode layer, the first power generation layer, and the first upper transparent electrode layer are stacked in that order from the substrate side. The second lower transparent electrode layer, the second power generation layer, and the second upper transparent electrode layer are stacked in that order from the substrate side. The first metal interconnection wiring has a portion that extends in the stacking direction. The first lower transparent electrode layer and the second upper transparent electrode layer are electrically connected through the first metal interconnection wiring. The first metal interconnection wiring is physically separated from the first upper transparent electrode layer.

## Description

### FIELD

Embodiments described herein relate generally to a solar cell module, a multi-junction solar cell module, and a photovoltaic power generation system.

### BACKGROUND

One type of new solar cell uses cuprous oxide (Cu₂O) as the light-absorbing layer. Cu₂O is a wide-bandgap semiconductor. Because Cu₂O is a safe and inexpensive material composed of copper and oxygen, which are abundantly available on Earth, it is expected that high-efficiency and low-cost solar cells can be realized.

By combining a solar-cell module that uses a wide-bandgap semiconductor to absorb short-wavelength light with a solar-cell module that uses silicon to absorb long-wavelength light, it is expected that the total power output of the solar-cell modules can be increased.

### BRIEF DESCRIPTION OF THE DRAWINGS

FIG. 1 is a perspective schematic diagram of a solar cell module according to an embodiment;
FIG. 2 is a schematic cross-sectional diagram of a solar cell module according to an embodiment;
FIG. 3 is a schematic cross-sectional diagram of a solar cell module according to an embodiment;
FIG. 4 is a schematic cross-sectional diagram of a solar cell module according to an embodiment;
FIG. 5 is a perspective schematic diagram of a solar cell module according to an embodiment;
FIG. 6 is a schematic cross-sectional diagram of a solar cell module according to an embodiment;
FIG. 7 is a schematic cross-sectional diagram of a solar cell module according to an embodiment;
FIG. 8 is a schematic cross-sectional diagram of a solar cell module according to an embodiment;
FIG. 9 is a schematic top-view diagram of a solar cell module according to an embodiment;
FIG. 10 is a schematic top-view diagram of a solar cell module according to an embodiment;
FIG. 11 is a schematic top-view diagram of a solar cell module according to an embodiment;
FIG. 12 is a schematic top-view diagram of a solar cell module according to an embodiment;
FIG. 13 is a perspective schematic diagram of a solar cell module according to an embodiment;
FIG. 14 is a perspective schematic diagram of a solar cell module according to an embodiment;
FIG. 15 is a perspective schematic diagram of a solar cell module according to an embodiment;
FIG. 16 is a perspective schematic diagram of a solar cell module according to an embodiment;
FIG. 17 is a schematic diagram of a manufacturing method of a solar cell module according to an embodiment;
FIG. 18 is a schematic diagram of a manufacturing method of a solar cell module according to an embodiment;
FIG. 19 is a schematic diagram of a manufacturing method of a solar cell module according to an embodiment;
FIG. 20 is a schematic diagram of a manufacturing method of a solar cell module according to an embodiment;
FIG. 21 is a schematic diagram of a manufacturing method of a solar cell module according to an embodiment;
FIG. 22 is a schematic diagram of a manufacturing method of a solar cell module according to an embodiment;
FIG. 23 is a schematic diagram of a manufacturing method of a solar cell module according to an embodiment;
FIG. 24 is a schematic diagram of a manufacturing method of a solar cell module according to an embodiment;
FIG. 25 is a schematic cross-sectional diagram of a solar cell module according to an embodiment;
FIG. 26 is a schematic diagram of a manufacturing method of a solar cell module according to an embodiment;
FIG. 27 is a schematic diagram of a manufacturing method of a solar cell module according to an embodiment;
FIG. 28 is a schematic diagram of a manufacturing method of a solar cell module according to an embodiment;
FIG. 29 is a schematic diagram of a manufacturing method of a solar cell module according to an embodiment;
FIG. 30 is a schematic diagram of a manufacturing method of a solar cell module according to an embodiment;
FIG. 31 is a schematic diagram of a manufacturing method of a solar cell module according to an embodiment;
FIG. 32 is a schematic diagram of a manufacturing method of a solar cell module according to an embodiment;
FIG. 33 is a schematic diagram of a manufacturing method of a solar cell module according to an embodiment;
FIG. 34 is a schematic cross-sectional diagram of a solar cell module according to an embodiment;
FIG. 35 is a schematic diagram of a manufacturing method of a solar cell module according to an embodiment;
FIG. 36 is a schematic diagram of a manufacturing method of a solar cell module according to an embodiment;
FIG. 37 is a schematic cross-sectional diagram of a solar cell module according to an embodiment;
FIG. 38 is a schematic diagram of a manufacturing method of a solar cell module according to an embodiment;
FIG. 39 is a schematic cross-sectional diagram of a solar cell module according to an embodiment;
FIG. 40 is a schematic diagram of a manufacturing method of a solar cell module according to an embodiment;
FIG. 41 is a schematic cross-sectional diagram of a solar cell module according to an embodiment;
FIG. 42 is a schematic diagram of a manufacturing method of a solar cell module according to an embodiment;
FIG. 43 is a schematic diagram of a manufacturing method of a solar cell module according to an embodiment;
FIG. 44 is a schematic diagram of a manufacturing method of a solar cell module according to an embodiment;
FIG. 45 is a schematic diagram of a manufacturing method of a solar cell module according to an embodiment;
FIG. 46 is a schematic cross-sectional diagram of a solar cell module according to an embodiment;
FIG. 47 is a schematic top-view diagram of a solar cell module according to an embodiment;
FIG. 48 is a schematic diagram of a multi-junction solar cell module according to an embodiment;
FIG. 49 is a schematic diagram of a photovoltaic power generation system according to an embodiment;
FIG. 50 is a schematic diagram of a vehicle according to an embodiment; and
FIG. 51 is a schematic diagram of a drone according to an embodiment.

### DETAILED DESCRIPTION

A solar cell module according to an embodiment comprises a substrate; a first solar cell provided on the substrate; a first solar cell including a first upper transparent electrode layer, a first power generation layer, and a first lower transparent electrode layer; a second solar cell provided on the substrate, adjacent to the first solar cell, the second solar cell including a second upper transparent electrode layer, a second power generation layer, and a second lower transparent electrode layer; and a first metal interconnection wiring that electrically connects the first solar cell and the second solar cell. The first upper transparent electrode layer and the second upper transparent electrode layer are provided on the light incident side, and the first solar cell and the second solar cell are arranged in a first direction extending along a width direction of the first solar cell. The first lower transparent electrode layer, the first power generation layer, and the first upper transparent electrode layer are stacked in that order from the substrate side. The second lower transparent electrode layer, the second power generation layer, and the second upper transparent electrode layer are stacked in that order from the substrate side. The first metal interconnection wiring has a portion that extends in the stacking direction of the second upper transparent electrode layer, the second power generation layer, and the second lower transparent electrode layer. The first lower transparent electrode layer and the second upper transparent electrode layer are electrically connected through the first metal interconnection wiring. The first metal interconnection wiring is physically separated from the first upper transparent electrode layer.

With reference to the drawings, a preferred embodiment of the present invention will be described in detail. Unless otherwise specifically indicated, the physical property values shown are those measured at 25 °C and 1 atm (atmospheric pressure) . "Average" denotes an arithmetic mean. Each concentration is the average concentration in the region or layer concerned. In any layer, "a specific element is contained (included)" means that the element has been confirmed to exist, for example, by secondary ion mass spectrometry (SIMS); "a specific element is not contained" means that the element could not be confirmed, for example, by SIMS.

In the specification, "/" denotes the division sign. However, in the expression "or/and" the "/" means "or". In the specification, "·" and "*" denote multiplication. In the specification, "." denotes a decimal point.

The thickness and structure of members described in the specification can be known, for example, from one or more of images obtained by SEM (Scanning Electron Microscope), TEM (Transmission Electron Microscope), HAADF-STEM (High-Angle Annular Dark Field Scanning Transmission Electron Microscopy), and the like. The boundaries of the members described in the specification can be determined from one or more images obtained by scanning electron microscopy or transmission electron microscopy, SEM-EDS (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEM, PL (Photoluminescence), XPS (X-ray Photoelectron Spectroscopy), or the like. These analysis methods are examples and do not negate the specific analytical methods described in the specification.

### (FIRST EMBODIMENT)

A first embodiment relates to a solar cell module. A solar cell module according to an embodiment comprises a substrate; a first solar cell provided on the substrate, the first solar cell including the first upper transparent electrode layer, the first power generation layer, and the first lower transparent electrode layer; a second solar cell provided on the substrate, adjacent to the first solar cell, the second solar cell including the second upper transparent electrode layer, the second power generation layer, and the second lower transparent electrode layer; and a first metal interconnection wiring that electrically connects the first solar cell and the second solar cell. The first upper transparent electrode layer and the second upper transparent electrode layer are provided on the light incident side, and the first solar cell and the second solar cell are arranged in a first direction extending along the width direction of the first solar cell. The first lower transparent electrode layer, the first power generation layer, and the first upper transparent electrode layer are stacked in that order from the substrate side. The second lower transparent electrode layer, the second power generation layer, and the second upper transparent electrode layer are stacked in that order from the substrate side. The first metal interconnection wiring has a portion that extends in the stacking direction of the second upper transparent electrode layer, the second power generation layer, and the second lower transparent electrode layer. The first lower transparent electrode layer and the second upper transparent electrode layer are electrically connected (short-circuited) through the first metal interconnection wiring. The first metal interconnection wiring is physically separated from the first upper transparent electrode layer.

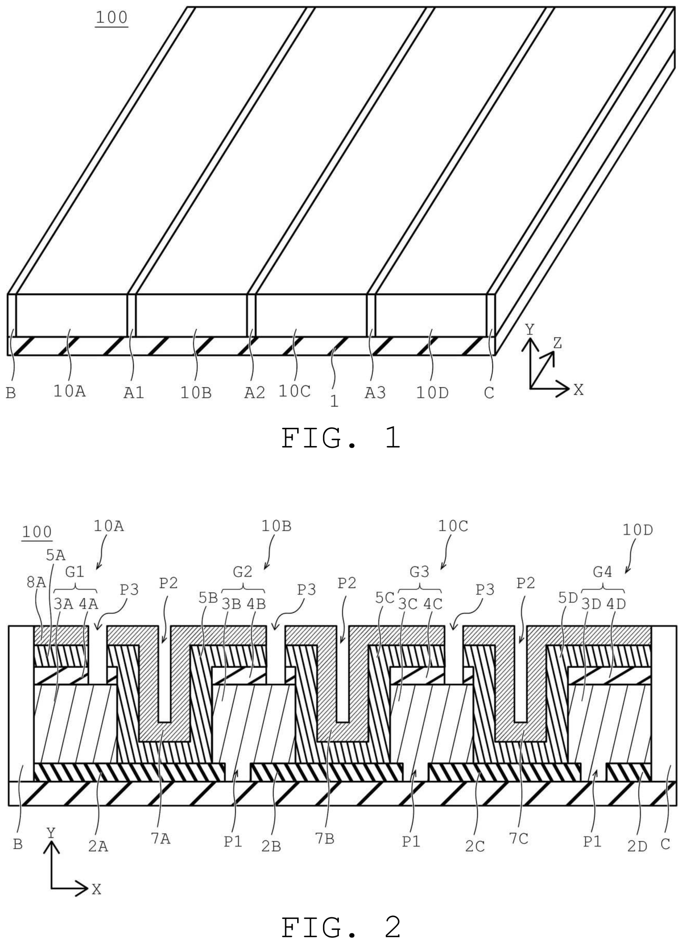

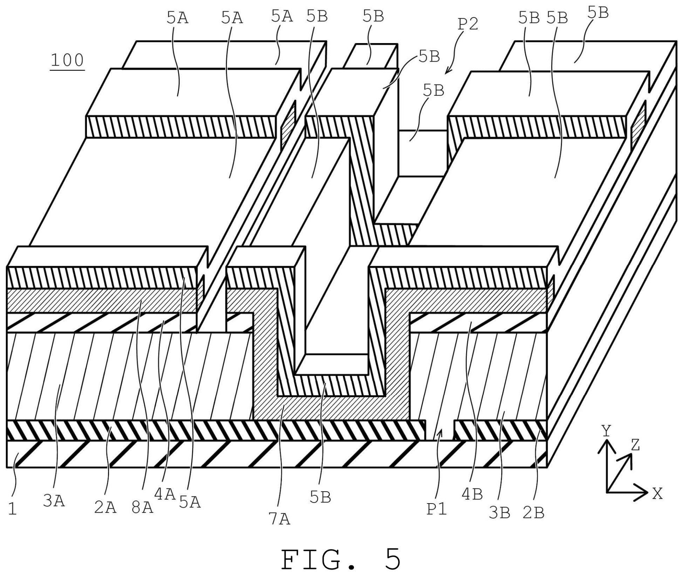

FIG. 1 shows a perspective schematic diagram of a solar cell module 100 according to the first embodiment. FIGS. 2, 3, 4, 6, 7 and 8 show schematic cross-sectional diagrams of the solar cell module 100. FIG. 5 shows a perspective schematic diagram of the solar cell module 100. The solar cell module 100 includes a substrate 1, a first solar cell 10A, a second solar cell 10B, a third solar cell 10C and a fourth solar cell 10D. The side of the solar cell module 100 opposite the substrate 1 side is the light incident side. The solar cell module 100 of the first embodiment has an array-cell structure in which multiple solar cells are arranged side by side.

The substrate 1 is a transparent substrate. Multiple solar cells are provided on the substrate 1 arranged in the first direction (X direction). The first solar cell 10A, the second solar cell 10B, the third solar cell 10C and the fourth solar cell 10D are stacked on the substrate 1 in the second direction (Y direction). The first direction (X direction) extends along the width direction of the first solar cell 10A.

The substrate 1 may be an acrylic, polyimide, polycarbonate, polyethylene terephthalate (PET), polypropylene (PP), fluorine-based resin (such as polytetrafluoroethylene (PTFE), perfluoroethylene-propylene copolymer (FEP), ethylene-tetrafluoroethylene copolymer (ETFE), polychlorotrifluoroethylene (PCTFE), perfluoroalkoxy alkane (PFA), etc.), polyarylate, polysulfone, polyether sulfone or polyether imide, i.e., an organic-based substrate, or an inorganic substrate such as soda-lime glass, ultra-clear glass, chemically strengthened glass or quartz. The substrate 1 may comprise a stack of the above-listed substrates.

Preferably, the substrate 1 is soda-lime glass, ultra-clear glass, chemically strengthened glass or quartz, and more preferably soda-lime glass, ultra-clear glass or quartz.

The first solar cell 10A includes a first lower transparent electrode layer 2A, a first power generation layer G1 and a first upper transparent electrode layer 5A. The first lower transparent electrode layer 2A, the first power generation layer G1 and the first upper transparent electrode layer 5A are stacked in that order from the substrate 1 side. The first power generation layer G1 varies according to the component of the solar cell and, for example, includes a first p-type light-absorbing layer 3A and a first n-type layer 4A.

The second solar cell 10B includes a second lower transparent electrode layer 2B, a second power generation layer G2 and a second upper transparent electrode layer 5B. The second lower transparent electrode layer 2B, the second power generation layer G2 and the second upper transparent electrode layer 5B are stacked in that order from the substrate 1 side. The second power generation layer G2 varies according to the component of the solar cell and, for example, includes a second p-type light-absorbing layer 3B and a second n-type layer 4B.

The first solar cell 10A and the second solar cell 10B are connected by a first joint section A1. In the first joint section A1, the first lower transparent electrode layer 2A and the second upper transparent electrode layer 5B are electrically connected. The first joint section A1 electrically connects the first solar cell 10A and the second solar cell 10B in series.

The first upper transparent electrode layer 5A of the solar cell module 100 is electrically connected to a first extraction electrode B.

The third solar cell 10C includes a third lower transparent electrode layer 2C, a third power generation layer G3 and a third upper transparent electrode layer 5C. The third lower transparent electrode layer 2C, the third power generation layer G3 and the third upper transparent electrode layer 5C are stacked in that order from the substrate 1 side. The third power generation layer G3 varies according to the component of the solar cell and, for example, includes a third p-type light-absorbing layer 3C and a third n-type layer 4C.

The second solar cell 10B and the third solar cell 10C are connected by a second joint section A2. In the second joint section A2, the second lower transparent electrode layer 2B and the third upper transparent electrode layer 5C are electrically connected. The second joint section A2 electrically connects the second solar cell 10B and the third solar cell 10C in series.

The fourth solar cell 10D includes a fourth lower transparent electrode layer 2D, a fourth power generation layer G4, and a fourth upper transparent electrode layer 5D. The fourth lower transparent electrode layer 2D, the fourth power generation layer G4, and the fourth upper transparent electrode layer 5D are stacked in that order from the substrate 1 side. The fourth power generation layer G4 varies according to the component of the solar cell and, for example, includes a fourth p-type light-absorbing layer 3D and a fourth n-type layer 4D.

The third solar cell 10C and the fourth solar cell 10D are connected by a third joint section A3. In the third joint section A3, the third lower transparent electrode layer 2C and the fourth upper transparent electrode layer 5D are electrically connected. The third joint section A3 electrically connects the third solar cell 10C and the fourth solar cell 10D in series.

The fourth lower transparent electrode layer 2D of the solar cell module 100 is electrically connected to a second extraction electrode C.

The solar cell module 100 shown in FIG. 1 has a configuration in which four solar cells are arranged in the first direction (X direction). The number of solar cells contained in the solar cell module 100 is two or more. The number of solar cells contained in the solar cell module 100 is not limited to four. One or more solar cells, not shown in the figure, may be present between the second solar cell 10B and the third solar cell 10C, and they may be connected in the same manner as the other solar cells.

The lower transparent electrode layer (hereinafter, the description of the lower transparent electrode layer applies commonly to the first lower transparent electrode layer 2A, the second lower transparent electrode layer 2B, the third lower transparent electrode layer 2C and the fourth lower transparent electrode layer 2D) is provided on the substrate 1. The lower transparent electrode layer is a planar conductive film. The lower transparent electrode layer is a conductive layer having light-transmittance. It is preferable that the lower transparent electrode layer include one or more transparent conductive oxide films. As transparent conductive oxide films, semiconductor conductive films such as indium tin oxide (ITO), aluminum-doped zinc oxide (AZO), boron-doped zinc oxide (BZO), gallium-doped zinc oxide (GZO), doped tin oxide, titanium-doped indium oxide (ITiO), indium zinc oxide (IZO) or indium gallium zinc oxide (IGZO), hydrogen-doped indium oxide (IOH), etc., may be used, and the selection is not particularly limited. The transparent conductive oxide film may be a multilayer stack comprising multiple films. As dopants for tin-oxide-type films, one or more elements selected from the group consisting of In, Si, Ge, Ti, Cu, Sb, Nb, Ta, W, Mo, F, and Cl may be employed, without particular limitation. It is preferable that the lower transparent electrode layer includes a doped tin-oxide film in which one or more elements selected from the group consisting of In, Si, Ge, Ti, Cu, Sb, Nb, Ta, W, Mo, F, and Cl are doped. It is preferable that the one or more dopant elements selected from the group consisting of In, Si, Ge, Ti, Cu, Sb, Nb, Ta, W, Mo, F, and Cl be present at ten atomic percent or less relative to the tin element in the tin-oxide film. As the lower transparent electrode layer, a stacked film comprising the transparent conductive oxide film and a metal film may be used. The metal included in the metal film (including alloys) is not particularly limited and may be Mo, Au, Cu, Ag, Al, Ta, W, etc. In addition, it is preferable that the lower transparent electrode layer include a dot-type, line-type or mesh-type electrode (one or more selected from the group consisting of metals, alloys, graphene, conductive nitrides and conductive oxides) positioned between the oxide transparent conductive film and the substrate 1. The dot-type, line-type or mesh-type metal should have an opening ratio of fifty percent or more with respect to the transparent conductive oxide film. The dot-type, line-type or mesh-type metal may be Mo, Au, Cu, Ag, Al, Ta, W, etc., without particular limitation. When a metal film is used for the lower transparent electrode layer, a film thickness of 5 nm or less is preferable from the viewpoint of transmittance. When a line-type or mesh-type metal film is used, the thickness limitation does not apply to the metal film as long as the transmittance is ensured by the openings.

Specified examples of the lower transparent electrode layer include a transparent electrode layer consisting of an ITO film, and a stacked film comprising an ITO film provided on the substrate 1 side and a doped tin-oxide film provided on the film.

The thickness of the lower transparent electrode layer is preferably 50 nm or more and 500 nm or less, more preferably 50 nm or more and 300 nm or less, and even more preferably 75 nm or more and 200 nm or less.

The electrical polarity of the first lower transparent electrode layer 2A, the second lower transparent electrode layer 2B, the third lower transparent electrode layer 2C, and the fourth lower transparent electrode layer 2D is the same. In other words, each of the first lower transparent electrode layer 2A, the second lower transparent electrode layer 2B, the third lower transparent electrode layer 2C and the fourth lower transparent electrode layer 2D serves as either the positive electrode or the negative electrode of the respective solar cells 10A through 10D.

An intermediate layer, not shown in the drawings, may be provided between the lower transparent electrode layer and the substrate 1.

The power generation layer (hereinafter, the description of the power generation layer applies commonly to the first power generation layer G1, the second power generation layer G2, the third power generation layer G3 and the fourth power generation layer G4) includes a semiconductor layer that performs photo-electric conversion. The power generation layer may include a semiconductor layer comprising, for example, a cuprous oxide compound, compound having a chalcopyrite structure such as CIGS or CGS, compound having a kesterite structure, compound having a stannite structure, amorphous silicon, or compound having a perovskite structure.

When a cuprous oxide compound, a compound having a chalcopyrite-type structure, a compound having a kesterite structure or a compound having a stannite structure is included in the power generation layer, it is preferable that a p-type light-absorbing layer and an n-type layer that includes the cuprous oxide compound, the chalcopyrite-type compound, the kesterite-type compound or the stannite-type compound are included in the power generation layer.

When the power generation layer includes amorphous silicon, for example, an amorphous-silicon semiconductor layer forming a p-i-n junction is preferably included in the power generation layer.

When the power generation layer includes a compound having a perovskite structure, for example, an electron-transport layer, a semiconductor layer including a perovskite-structured compound and a hole-transport layer are preferably included in the power generation layer.

The power generation layer preferably includes the p-type light-absorbing layer (the description of the p-type light-absorbing layer below refers to the first p-type light-absorbing layer 3A, the second p-type light-absorbing layer 3B, the third p-type light-absorbing layer 3C and the fourth p-type light-absorbing layer 3D) and the n-type layer (the description of the n-type layer below refers to the first n-type layer 4A, the second n-type layer 4B, the third n-type layer 4C and the fourth n-type layer 4D). It is even more preferable that the p-type light-absorbing layer including the cuprous oxide compound and the n-type layer.

The first power generation layer G1 of the first solar cell 10A preferably includes the first p-type light-absorbing layer 3A and the first n-type layer 4A. It is preferable that the first p-type light-absorbing layer 3A be positioned between the first lower transparent electrode layer 2A and the first n-type layer 4A. It is preferable that the first n-type layer 4A be positioned between the first p-type light-absorbing layer 3A and the first upper transparent electrode layer 5A.

The second power generation layer G2 of the second solar cell 10B preferably includes the second p-type light-absorbing layer 3B and the second n-type layer 4B. It is preferable that the second p-type light-absorbing layer 3B be positioned between the second lower transparent electrode layer 2B and the second n-type layer 4B. It is preferable that the second n-type layer 4B be positioned between the second p-type light-absorbing layer 3B and the second upper transparent electrode layer 5B.

The third power generation layer G3 of the third solar cell 10C preferably includes the third p-type light-absorbing layer 3C and the third n-type layer 4C. It is preferable that the third p-type light-absorbing layer 3C be positioned between the third lower transparent electrode layer 2C and the third n-type layer 4C. It is preferable that the third n-type layer 4C be positioned between the third p-type light-absorbing layer 3C and the third upper transparent electrode layer 5C.

The fourth power generation layer G4 of the fourth solar cell 10D preferably includes the fourth p-type light-absorbing layer 3D and the fourth n-type layer 4D. It is preferable that the fourth p-type light-absorbing layer 3D be positioned between the fourth lower transparent electrode layer 2D and the fourth n-type layer 4D. It is preferable that the fourth n-type layer 4D be positioned between the fourth p-type light-absorbing layer 3D and the fourth upper transparent electrode layer 5D.

An intermediate layer, not shown in the diagram, may be provided between the lower transparent electrode layer and the power generation layer.

An intermediate layer, not shown in the diagram, may be provided between the upper transparent electrode layer (the description of the upper transparent electrode layer below refers to the first upper transparent electrode layer 5A, the second upper transparent electrode layer 5B, the third upper transparent electrode layer 5C and the fourth upper transparent electrode layer 5D) and the power generation layer.

It is preferable that the p-type light-absorbing layer be a semiconductor layer that includes the cuprous oxide compound. It is preferable that the p-type light-absorbing layer be polycrystalline of the cuprous oxide compound. Trace amounts of one or more cuprous oxide-related impurities selected from the group consisting of Cu, CuO and Cu(OH)₂ may be present in the p-type light-absorbing layer.

When all elements other than oxygen included in the p-type light-absorbing layer are taken as 100 atomic %, it is preferable that the Cu content in the p-type light-absorbing layer be 90 atomic% or more and less than 100 atomic%; preferably 95 atomic% or more and less than 100 atomic%; more preferably 98 atomic% or more and less than 100 atomic%; and even more preferably 99 atomic% or more and less than 100 atomic%.

When all elements other than oxygen included in the p-type light-absorbing layer are taken as 100 atomic%, it is preferable that the copper content in the p-type light-absorbing layer be 90 atomic% or more and 99.9 atomic% or less; preferably 95.0 atomic% or more and 99.9 atomic% or less; more preferably 98 atomic% or more and 99.9 atomic% or less; and even more preferably 99.0 atomic% or more and 99.9 atomic% or less.

The cuprous oxide compound includes copper and oxygen and may further include an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, and Ca.

In the cuprous oxide compound, it is preferable that the amount of oxygen atoms relative to the amount of copper atoms (the copper atom count being set to 1) be 0.48 or more and 0.56 or less. When the oxygen content is higher relative to copper, the proportion of cuprous oxide in the compound increases, the band-gap narrows, and the transmittance of the p-type light-absorbing layer is reduced; this is undesirable. Conversely, when the oxygen content is lower relative to copper, the copper content in the compound increases, also reducing transmittance; this is undesirable. Moreover, when the oxygen-to-copper ratio does not satisfy the above range, it becomes difficult for the cuprous oxide compound to adopt the cuprite (Cu₂O) crystal structure.

It is preferable that the amount of the cuprous oxide compound in the p-type light-absorbing layer be 95 wt% or more and less than 100 wt%; more preferably 98 wt% or more and less than 100 wt%; even more preferably 99 wt% or more and 100 wt% or less. The p-type light-absorbing layer may be composed of 100 wt % cuprous oxide compound.

When the amount of hetero-phase present in the p-type light-absorbing layer is small and its crystallinity is good, the transmittance of the p-type light-absorbing layer becomes high, which is desirable. By means such as incorporating elements other than Cu and O into the p-type light-absorbing layer, the band-gap of the p-type light-absorbing layer can be adjusted. It is preferable that the band-gap of the p-type light-absorbing layer be 2.0 eV or more and 2.2 eV or less. With a band-gap in this range, a solar cell that uses Si as its light-absorbing layer can be employed as a bottom cell, and the solar cell of the present embodiment can be used as a top cell in a multi-junction solar cell, thereby allowing efficient utilization of sunlight by both the top cell and the bottom cell.

It is preferable that the p-type light-absorbing layer include Sn and/or Sb. The Sn or Sb in the p-type light-absorbing layer may be added directly to the p-type light-absorbing layer or may originate from the lower transparent electrode layer. Gallium (Ga) that appears in the p-type light-absorbing layer is not present in the raw material used to deposit the p-type light-absorbing layer; rather, Ga present in the n-type layer diffuses into the p-type light-absorbing layer. When other elements are used during the deposition of the n-type layer, those elements may also diffuse into the p-type light-absorbing layer.

The composition ratio of the foregoing p-type light-absorbing layer refers to the overall composition ratio of the p-type light-absorbing layer. In addition, the compound-composition ratio of the p-type light-absorbing layer which is described above, is preferably satisfied throughout the p-type light-absorbing layer.

It is preferable that the p-type light-absorbing layer have a p+ (p plus) region on the side facing the lower transparent electrode layer.

It is preferable that the p-type light-absorbing layer have a p- (p minus) region on the side facing the n-type layer.

It is preferable that the p-type light-absorbing layer have a p- (p minus) region on the side facing the n-type layer and a p+ (p plus) region on the side facing the lower transparent electrode layer.

It is preferable that the p-type light-absorbing layer be formed, for example, by sputtering. Specifically, a member on which the lower transparent electrode layer has been formed on the substrate 1 is heated to a temperature of 300 °C or more and 1000 °C or less, and the deposition is carried out at an oxygen partial pressure of 0.01 Pa or more and 4.8 Pa or less, with a flow rate of 0.02 µm/min or more and 20 µm/min or less. From the viewpoint of forming a highly transmissive and large-grain-size polycrystalline film, when the deposition rate is denoted by d, the oxygen partial pressure is preferably 0.20×d Pa or more and 1.00×d Pa or less (for example, when high-temperature sputtering is performed at a temperature higher than 600 °C, the preferred range is 0.20×d Pa or more and 0.50×d Pa or less; for low-temperature sputtering the preferred range is 0.55×d Pa or more and 1.00×d Pa or less). Moreover, the heating temperature is more preferably 600 °C or more and 850 °C or less. An element represented by M1 may be added during the deposition.

The n-type layer is an n-type semiconductor layer. The n-type layer is positioned between the p-type light-absorbing layer and the upper transparent electrode layer. It is preferable that the n-type layer be provided on the p-type light-absorbing layer. The n-type layer may be formed, for example, by ALD or CVD; the ALD method is more preferable. Because ALD enables the formation of a dense n-type layer, the n-type layer can be a thin film having a thickness of 3 nm or more and 100 nm or less. The density of the n-type layer is preferably higher than the densities of the lower transparent electrode layer and the upper transparent electrode layer.

The n-type layer preferably includes a compound (oxide) whose main component is Ga. The n-type layer may include other oxides mixed with the Ga-based oxide, or it may be doped with other elements, or a Ga-based oxide doped with other elements may be mixed with other oxides. The n-type layer may be a single layer or a multilayer. Among the metal elements contained in the n-type layer, Ga is preferably present at 40 atomic % or more, and more preferably at 50 atomic % or more. The metal elements including Ga in the n-type layer may be graded so that their composition ratio decreases from the side of the p-type light-absorbing layer toward the side of the upper transparent electrode layer 5.

The n-type layer preferably includes an oxide comprising Ga and an element represented by M2. M2 is one or more elements selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr, and Nd.

It is preferable that 90 wt % or more and 100 wt % or less of the n-type layer be an oxide including M2 and Ga. It is more preferable that 95 wt % or more and 100 wt % or less be such an oxide. It is even more preferable that 98 wt % or more and 100 wt % or less be represented by an oxide comprising M2 and Ga. The Cu present in the n-type layer does not originate from the raw material used to deposit the n-type layer; rather, Cu that is included in the p-type light-absorbing layer diffuses into the n-type layer. When other elements are used during the deposition of the p-type light-absorbing layer, those elements may also diffuse into the n-type layer.

The film thickness of the n-type layer is typically 3 nm or more and 100 nm or less. When the thickness is less than 3 nm, poor coverage of the n-type layer can cause leakage current and degrade performance; when coverage is good, the thickness is not limited to this range. When the thickness exceeds 50 nm, excessive resistance of the n-type layer and reduced transmittance can lead to performance degradation and a decrease in short-circuit current. Accordingly, it is more preferable that the thickness of the n-type layer be 3 nm or more and 20 nm or less; and even more preferably 5 nm or more and 20 nm or less. The n-type layer may be placed between the upper transparent electrode layer and the p-type light-absorbing layer, or it may be positioned on a side surface on the first solar cell 10A side as the second p-type light-absorbing layer 3B; in either case, a thickness of 3 nm or more and 100 nm or less is desirable.

The upper transparent electrode layer is the electrode on the n-type layer side that has light transmittance in the visible region. It is preferable that the upper transparent electrode layer be provided on the n-type layer. An intermediate layer not shown in the diagram may be placed between the n-type layer and the upper transparent electrode layer. It is preferable that the upper transparent electrode layer use a transparent conductive oxide film. The transparent conductive oxide film may be one or more semiconductor conductive films selected from the group consisting of indium tin oxide, aluminum-doped zinc oxide, boron-doped zinc oxide, gallium-doped zinc oxide, indium-doped zinc oxide, titanium-doped indium oxide, indium gallium zinc oxide and hydrogen-doped indium oxide. As dopants for tin-oxide-type films, one or more elements selected from the group consisting of In, Si, Ge, Ti, Cu, Sb, Nb, Ta, W, Mo, F, and Cl may be used without particular limitation. To lower the resistance of the transparent conductive oxide film, the upper transparent electrode layer may include mesh- or line-shaped electrodes. The mesh or line electrodes may be Mo, Au, Cu, Ag, Al, Ta or W, etc., without particular limitation. Graphene may also be used for the upper transparent electrode layer; it is preferable that graphene be stacked with silver nanowires.

The thickness of the upper transparent electrode layer is determined by cross-sectional observation with an electron microscope or by a step-profiler; there is no particular limitation, but typically it is 35 nm or more and 2 µm or less.

The electrical polarity of the first upper transparent electrode layer 5A, the second upper transparent electrode layer 5B, the third upper transparent electrode layer 5C and the fourth upper transparent electrode layer 5D is the same. In other words, all of these layers are either the positive electrode or the negative electrode of each solar cell 10A through 10D.

The electrical polarity of the upper transparent electrode layer is opposite to the electrical polarity of the lower transparent electrode layer.

It is preferable that the upper transparent electrode layer be formed, for example, by ALD, CVD or sputtering.

Unless otherwise specified, the composition of compounds such as the p-type light-absorbing layer and the n-type layer refers to the overall average composition of the respective layer. For example, the composition of each layer can be obtained by analysis with secondary ion mass spectrometry (SIMS).

The solar cell module 100 includes a first isolation region P1, a second isolation region P2 and a third isolation region P3 (for example, a scribed region). The first isolation region P1 through the third isolation region P3 separate the individual cells of the first solar cell 10A through the fourth solar cell 10D.

The first isolation region P1 divides the lower transparent electrode layer. Because the lower transparent electrode layer is not a common electrode for multiple solar cells but an electrode independently provided for each individual solar cell, the lower transparent electrode layer is divided.

The second isolation region P2 divides the power generation layer. The second isolation region P2 is included in the joint section (hereinafter, the description of the joint section is common to the first joint section A1, the second joint section A2 and the third joint section A3). Wiring is provided within the second isolation region P2. The layers of upper transparent electrode layer, the power generation layer, and the lower transparent electrode layer are divided by the second isolation region P2, wiring which electrically connects the upper transparent electrode layer connecting to one power generation layer to the lower transparent electrode layer connecting to the next power generation layer is provided within the second isolation region P2. The bottom surface of the second isolation region P2 faces the surface of the lower transparent electrode layer opposite the substrate 1.

The third isolation region P3 divides the transparent electrode layer on the power generation layer. The third isolation region P3 may be provided optionally. In the diagram of FIG. 2, the electrical and physical connections between upper transparent electrode layers of the solar cell module 100 can be segmented by the third isolation region P3.

The first joint section A1 includes a first metal interconnection wiring 7A that electrically connects the first solar cell 10A and the second solar cell 10B. The first joint section A1 constitutes a portion of the first solar cell 10A and a portion of the second solar cell 10B. The first metal interconnection wiring 7A electrically connects the first solar cell 10A and the second solar cell 10B in series.

Below, the connection between the first solar cell 10A and the second solar cell 10B is described. The connections between the second solar cell 10B and the third solar cell 10C, and between the third solar cell 10C and the fourth solar cell 10D, are likewise described. The description of the connection between the first solar cell 10A and the second solar cell 10B also applies to the connection between the second solar cell 10B and the third solar cell 10C and to the connection between the third solar cell 10C and the fourth solar cell 10D.

It is preferable that the first metal interconnection wiring 7A be arranged in multiple lines alongside the third direction, which is the longitudinal direction of the solar cells. The multiple first metal interconnection wirings 7A may be connected to each other via the first joint section A1.

The first metal interconnection wiring 7A is not physically connected to the first upper transparent electrode layer 5A and the second lower transparent electrode layer 2B.

The first metal interconnection wiring 7A primarily comprises metal and/or alloy. It is preferable that at least 50 wt% of the first metal interconnection wiring 7A be metal and/or alloy, and it is even more preferable that at least 80wt % of the first metal interconnection wiring 7A be metal and/or alloy. It is also preferable that the first metal interconnection wiring 7A includes at least one element selected from the group consisting of Al, Au, Ag, Cu, Sc, Ti, V, Cr, Mn, Fe, Co, Ni, Zn, Y, Zr, Nb, Mo, Hf, and Ta. It is preferable that 50 wt% or more and 100 wt% or less of the first metal interconnection wiring 7A consist of at least one element selected from the group consisting of Al, Au, Ag, Cu, Sc, Ti, V, Cr, Mn, Fe, Co, Ni, Zn, Y, Zr, Nb, Mo, Hf, and Ta; more preferably 80 wt% or more and 100 wt% or less; and even more preferably 95 wt% or more and 100 wt% or less.

It is preferable that the sheet resistance (Ω/sq) of the first metal interconnection wiring 7A be lower than the sheet resistance of the first lower transparent electrode layer 2A and lower than the sheet resistance of the second upper transparent electrode layer 5B. It is also preferable that the sheet resistance of the first metal interconnection wiring 7A be 1 % or less of the sheet resistance of both the first lower transparent electrode layer 2A and the second upper transparent electrode layer 5B, and more preferably 0.1 % or less.

It is preferable that the resistivity (Ω·cm) of the first metal interconnection wiring 7A be lower than the resistivity of the first lower transparent electrode layer 2A and lower than the resistivity of the second upper transparent electrode layer 5B. It is also preferable that the resistivity of the first metal interconnection wiring 7A be 1 % or less of the resistivity of both the first lower transparent electrode layer 2A and the second upper transparent electrode layer 5B, and more preferably 0.1 % or less.

It is preferable that the first metal interconnection wiring 7A have a portion extending in the stacking direction (Y-direction) of the second upper transparent electrode layer 5B, the second power generation layer G2 and the second lower transparent electrode layer 2B. It is preferable that the portion of the first metal interconnection wiring 7A that extends in the Y-direction be aligned along the side surface of the second isolation region P2 on the second power generation layer G2 side. In the schematic diagram of FIG. 2, the side surface of the second isolation region P2 on the second power generation layer G2 side is positioned most toward the first solar cell 10A among the first solar cell 10A and the second solar cell 10B.

The first metal interconnection wiring 7A short-circuits the first lower transparent electrode layer 2A and the second upper transparent electrode layer 5B. That the first metal interconnection wiring 7A short-circuits the first lower transparent electrode layer 2A means that the first metal interconnection wiring 7A is electrically connected to the first lower transparent electrode layer 2A and the second upper transparent electrode layer 5B (preferably in direct contact with each other), or that the second upper transparent electrode layer 5B, which is in direct contact with the first lower transparent electrode layer 2A, is in direct contact with the first metal interconnection wiring 7A. In other words, the first metal interconnection wiring 7A constitutes a portion of the conductive path that electrically connects the substrate-side of the first power generation layer G1 to the side opposite the substrate-side of the second power generation layer G2.

The first metal interconnection wiring 7A is physically separated from the first upper transparent electrode layer 5A. The first upper transparent electrode layer 5A does not short-circuit the first lower transparent electrode layer 2A nor the second upper transparent electrode layer 5B.

It is preferable that the first metal interconnection wiring 7A be stacked with the first lower transparent electrode layer 2A in the second isolation region P2. It is also preferable that the first metal interconnection wiring 7A be stacked with both the first lower transparent electrode layer 2A and the second upper transparent electrode layer 5B in the second isolation region P2. The surface of the first metal interconnection wiring 7A on the substrate 1 side within the second isolation region P2 is opposite to the surface of the first lower transparent electrode layer 2A on the substrate 1 side.

It is preferable that the portion of the first metal interconnection wiring 7A that extends in the Y-direction of the second upper transparent electrode layer 5B, the second power generation layer G2 and the second lower transparent electrode layer 2B, runs alongside a portion of the second upper transparent electrode layer 5B and electrically connects the first lower transparent electrode layer 2A and the second upper transparent electrode layer 5B. Otherwise, it is preferable that the portion of the first metal interconnection wiring 7A that extends in the Y-direction of the second upper transparent electrode layer 5B, the second power generation layer G2 and the second lower transparent electrode layer 2B, electrically connects the first lower transparent electrode layer 2A and the second upper transparent electrode layer 5B via that Y-directional portion of the first metal interconnection wiring 7A.

It is preferable that the first metal interconnection wiring 7A be in direct contact with the first lower transparent electrode layer 2A and/or the second upper transparent electrode layer 5B in the first joint section A1, where the first lower transparent electrode layer 2A and/or the second upper transparent electrode layer 5B in the first joint section A1 are located between the first solar cell 10A and the second solar cell 10B, and the first solar cell 10A and the second solar cell 10B are electrically connected through the first lower transparent electrode layer 2A and the second upper transparent electrode layer 5B or electrically-and-directly connected through the first lower transparent electrode layer 2A and the second upper transparent electrode layer 5B.

As shown in the diagram of FIG. 2, it is preferable that the portion of the first metal interconnection wiring 7A extending in the stacking direction (Y direction) of the second upper transparent electrode layer 5B, the second power generation layer G2 and the second lower transparent electrode layer 2B runs alongside a part of the second upper transparent electrode layer 5B and electrically connects the first lower transparent electrode layer 2A and the second upper transparent electrode layer 5B. It is also preferable that the first metal interconnection wiring 7A is in direct contact with the second upper transparent electrode layer 5B which is in direct contact with the second p-type light-absorbing layer 3B.

The first metal interconnection wiring 7A and other members can be identified in terms of their position and shape by cross-sectional observation of the solar cell module 100.

It is preferable that a first metal extraction wiring 8A, which is stacked on the first upper transparent electrode layer 5A, is provided. The first metal extraction wiring 8A electrically connects to the first upper transparent electrode layer 5A and electrically connects to the first extraction electrode B.

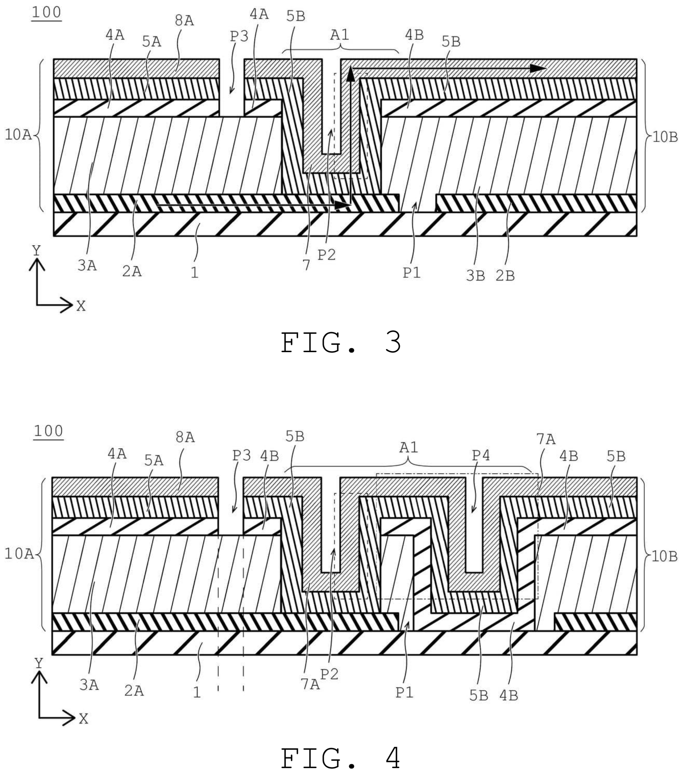

FIG. 3 shows a schematic diagram of the solar cell module 100 in which a portion of the schematic diagram of FIG. 2 is enlarged. In the schematic diagram of FIG. 3, the current-flow path is indicated with arrows. It is preferable that the first metal interconnection wiring 7A be provided so that the current-flow path avoids the portion of the second upper transparent electrode layer 5B that includes a surface in direct contact with the second p-type light-absorbing layer 3B. In the region enclosed by a broken line in the diagram of FIG. 3, the first metal interconnection wiring 7A, which is included in the first joint section A1, effectively reduces the wiring resistance for connecting the first solar cell 10A and the second solar cell 10B.

FIG. 4 shows a schematic diagram of the solar cell module 100. FIG. 4 is an enlarged schematic diagram of the same position as the diagram of FIG. 3 and represents a variation example of the solar cell module 100 shown in FIG. 3. In the region enclosed by a broken line in the diagram of FIG. 4, the first metal interconnection wiring 7A, which is included in the first joint section A1, effectively reduces the wiring resistance for connecting the first solar cell 10A and the second solar cell 10B as described above.

The solar cell module 100 shown in FIG. 4 includes a fourth isolation region P4 in the first joint section A1. The fourth isolation region P4 is located on the side of the second solar cell 10B. The second isolation region P2 is located on the side of the first solar cell 10A, more toward the first solar cell 10A than the fourth isolation region P4. The fourth isolation region P4 separates a portion of the power generation layer, for example the p-type light-absorbing layer, within the first isolation region P1.

Within the fourth isolation region P4 of the solar cell module 100 shown in FIG. 4, the second p-type light-absorbing layer 3B is separated, and the second n-type layer 4B contacts the surface of the region of the substrate 1 that is located between the first lower transparent electrode layer 2A and the second lower transparent electrode layer 2B within the first isolation region P1. By this arrangement, the second n-type layer 4B can be placed between the first lower transparent electrode layer 2A and the second lower transparent electrode layer 2B, thereby reducing the leakage current between the first lower transparent electrode layer 2A and the second lower transparent electrode layer 2B. As shown in the configuration of FIG. 4, even when the second n-type layer 4B does not contact the surface of the substrate 1 region, it is sufficient that an n-type layer is placed between the lower transparent electrode layers.

Within the fourth isolation region P4 of the solar cell module 100 shown in FIG. 4, the second upper transparent electrode layer 5B is in direct contact with and stacked on the second n-type layer 4B.

In the fourth isolation region P4 of the solar cell module 100 shown in FIG. 4, the first metal interconnection wiring 7A is also provided on the second upper transparent electrode layer 5B. The first metal interconnection wiring 7A is also provided in the region enclosed by a single long-chain line, but the resistance-reduction effect per unit length of the first metal interconnection wiring 7A is larger in the region enclosed by the broken line.

By providing the fourth isolation region P4, the leakage current between the first solar cell 10A and the second solar cell 10B, for example the leakage current between the first power generation layer G1 and the second power generation layer G2, can be reduced.

A schematic diagram of the solar cell module 100 is shown in FIG. 5. FIG. 5 is a perspective diagram taken from the same viewpoint as the diagram of FIG. 4, and it is a variation example of the solar cell module 100 shown in FIG. 2. In the diagram of FIG. 5, the solar cell module 100 is such that the first metal interconnection wiring 7A is located between the second n-type layer 4B and the second upper transparent electrode layer 5B, the first metal interconnection wiring 7A is located between the first n-type layer 4A and the second upper transparent electrode layer 5B, and the first metal extraction wiring 8A is located between the first n-type layer 4A and the first upper transparent electrode layer 5A. This configuration is different from the solar cell module 100 shown in the diagram of FIG. 2, in which the first metal interconnection wiring 7A is provided on the second upper transparent electrode layer 5B and other members.

In the schematic diagram of FIG. 5, the solar cell module 100 includes a plurality of first metal interconnection wiring 7A that extend in the third direction (Z direction) and a plurality of first metal extraction wiring 8A that also extend in the third direction (Z direction). The plurality of first metal interconnection wiring 7A and the first metal extraction wiring 8A that are arranged in the third direction (Z direction) may be connected with each other in the third direction (Z direction) within the first joint section A1. The plurality of first metal interconnection wiring 7A and the first metal extraction wiring 8A that are arranged in the third direction (Z direction) may also be connected with each other in the third direction (Z direction) inside the second isolation region P2 and/or the fourth isolation region P4.

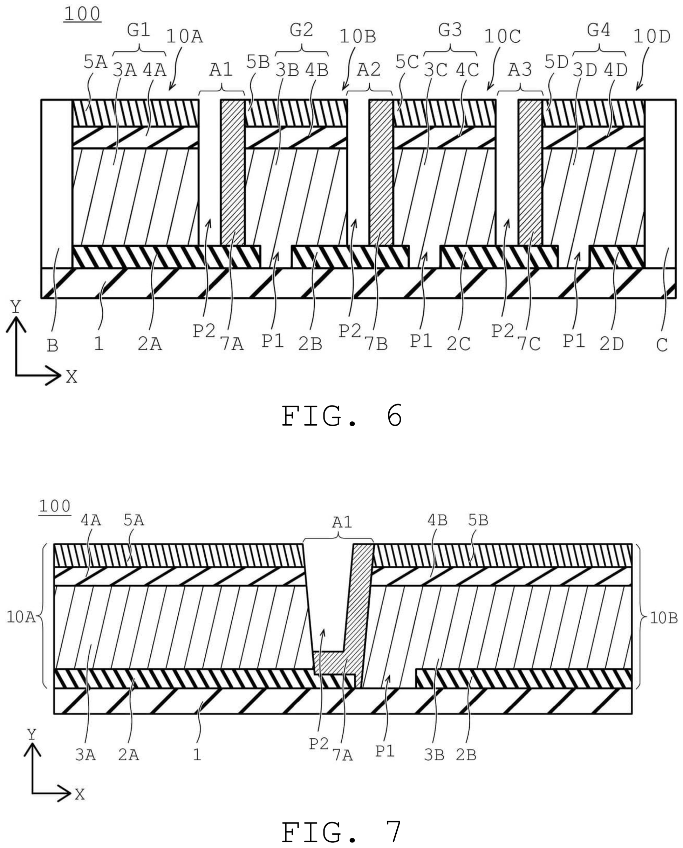

A schematic diagram of the solar cell module 100 is shown in FIG. 6. FIG. 6 is a cross-sectional diagram taken from the same viewpoint as the diagram of FIG. 4, and it is a variation example of the solar cell module 100 shown in FIG. 2. As illustrated in the schematic diagram of FIG. 6, it is preferable that the portion of the first metal interconnection wiring 7A which extends in the stacking direction (Y direction) of the second upper transparent electrode layer 5B, the second power generation layer G2 and the second lower transparent electrode layer 2B, electrically connects the first lower transparent electrode layer 2A and the second upper transparent electrode layer 5B through the portion that extends in the stacking direction. The solar cell module 100 of FIG. 6 is a variation example of the solar cell module 100 shown in the diagram of FIG. 2.

In the solar cell module 100 of FIG. 6, the first metal interconnection wiring 7A is provided in the region bounded by a broken line in the diagram of FIG. 3. The first metal interconnection wiring 7A electrically connects the physically separated first lower transparent electrode layer 2A and the second upper transparent electrode layer 5B. The side of the first metal interconnection wiring 7A on the substrate 1 side is in direct contact with the first lower transparent electrode layer 2A, and the side of the first metal interconnection wiring 7A opposite the substrate 1 is in direct contact with the second upper transparent electrode layer 5B. It is preferable that the first metal interconnection wiring 7A be in direct contact with the second p-type light-absorbing layer 3B.

A schematic diagram of the solar cell module 100 is shown in FIG. 7. FIG. 7 is a cross-sectional diagram taken from the same viewpoint as the diagram of FIG. 4, and it is a variation example of the solar cell module 100 shown in FIG. 2. In the solar cell module 100 of FIG. 7, the first metal interconnection wiring 7A is provided inside a tapered second isolation region P2. The first metal interconnection wiring 7A may extend vertically (perpendicular to the surface of the substrate 1) or may extend obliquely; both configurations are included within the scope of the present embodiment. The side surface of the second power generation layer G2 on the first power generation layer G1 side does not have to be in direct contact with the first lower transparent electrode layer 2A. The second isolation region P2 may also be formed in the first lower transparent electrode layer 2A. In such a case, the first lower transparent electrode layer 2A is either cut off or a recess is formed therein.

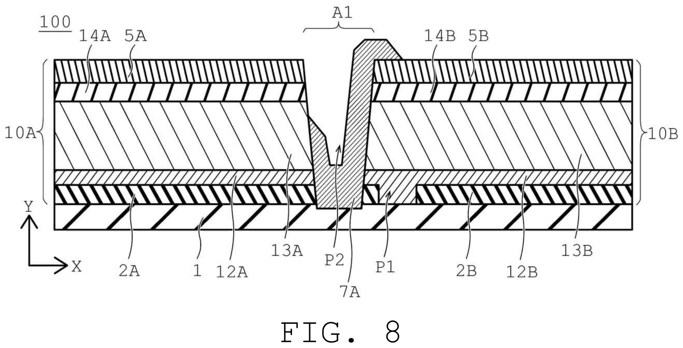

A schematic diagram of the solar cell module 100 is shown in FIG. 8. FIG. 8 is a cross-sectional diagram taken from the same viewpoint as the diagram of FIG. 4, and it is a variation example of the solar cell module 100 shown in FIG. 2. In the solar cell module 100 of FIG. 8, the first metal interconnection wiring 7A is provided inside a tapered second isolation region P2. The first solar cell 10A comprises a first hole-transport layer 12A, a first perovskite layer 13A and a first electron-transport layer 14A, and the second solar cell 10B comprises a second hole-transport layer 12B, a second perovskite layer 13B and a second electron-transport layer 14B. The first metal interconnection wiring 7A is provided up to an intermediate position within the first perovskite layer 13A and is connected to the side surface of the first lower transparent electrode layer 2A. In addition, a portion of the first metal interconnection wiring 7A is provided on a part of the upper surface of the second upper transparent electrode layer 5B. The thickness of the first metal interconnection wiring 7A may vary.

The reduction of wiring resistance achieved by using the first metal interconnection wiring 7A is described herein. Let L denote the wiring length between the first solar cell 10A and the second solar cell 10B. When the wiring length is L, for example, L / 3 and the first metal interconnection wiring 7A includes the portion whose length is L / 3 that extends in the stacking direction (Y direction) of the second upper transparent electrode layer 5B, the second power generation layer G2 and the second lower transparent electrode layer 2B, and when the first metal interconnection wiring 7A is provided over the entire portion that extends in the stacking direction (Y direction) of the second upper transparent electrode layer 5B, the second power generation layer G2 and the second lower transparent electrode layer 2B (i.e., when the first metal interconnection wiring 7A is placed in the region bounded by a broken line in FIG. 2 or FIG. 6), the resistance reduction obtained by the first metal interconnection wiring 7A is far more effective than simply replacing the length L / 3 of a conventional metal wiring with the first metal interconnection wiring 7A. However, when a length of the first metal interconnection wiring 7A equal to L / 3 is provided outside the portion that extends in the stacking direction (Y direction) of the second upper transparent electrode layer 5B, the second power generation layer G2 and the second lower transparent electrode layer 2B, the resistance reduction corresponding to the portion replaced by metal wiring is still obtained, but the effect is smaller than the resistance reduction described above. The portion of the first metal interconnection wiring 7A that extends in the stacking direction (Y direction) of the second upper transparent electrode layer 5B, the second power generation layer G2 and the second lower transparent electrode layer 2B contributes to the reduction of wiring resistance for the connection between the first solar cell 10A and the second solar cell 10B.

By using the first metal interconnection wiring 7A together with the second metal wiring 7B, the third metal wiring 7C and the first metal extraction wiring 8A to interconnect from the first solar cell 10A to the fourth solar cell 10D, the open-circuit voltage (Voc) does not decrease and the fill factor (FF) is improved by approximately 10 % compared with a solar cell module that does not employ the first metal interconnection wiring 7A, the second metal wiring 7B, the third metal wiring 7C or the first metal extraction wiring 8A. Consequently, the solar cell module 100 exhibits a substantially larger power output.

When the first metal interconnection wiring 7A is placed in the region bounded by a broken line, the current path between the first lower transparent electrode layer 2A and the second upper transparent electrode layer 5B within the second isolation region P2 primarily passes through the first metal interconnection wiring 7A. As a result, in the solar cell modules 100 shown in the forms of FIG. 2 through FIG. 8 and their variation examples, the first solar cell 10A and the second solar cell 10B can be connected by a low-resistance wiring, thereby contributing to a higher conversion efficiency of the solar cell module 100.

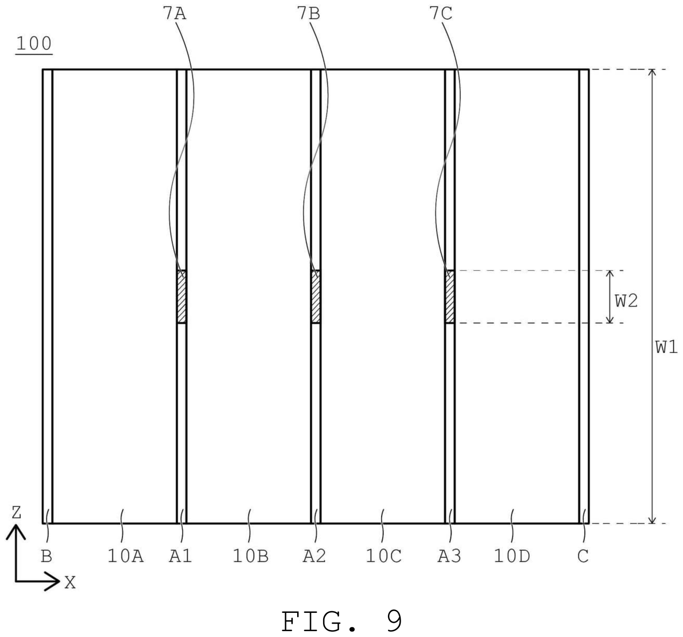

A schematic top-view diagrams of the solar cell module 100 are shown in FIGS. 9 through 12. The schematic top-view diagrams in FIGS. 9-12 indicate the positions where the first metal interconnection wiring 7A, the second metal wiring 7B and the third metal wiring 7C are provided.

As for the second metal wiring portion 7B and the third metal wiring portion 7C, the second metal wiring portion 7B and the third metal wiring portion 7C are the same as the first metal interconnection wiring 7A; therefore, the description of the second metal wiring portion 7B and the third metal wiring portion 7C is omitted here.

The composition (material and shape) of the first metal extraction wiring 8A is the same as that of the first metal interconnection wiring 7A. It is preferable that the first metal extraction wiring 8A be provided on the extension line of the first extraction electrode B side of the first metal interconnection wiring 7A.

In the diagram of FIG. 9, the first metal interconnection wiring 7A is provided within the first joint section A1. The first metal interconnection wiring 7A is not provided on the second solar cell 10B, more specifically, it is not provided on the power-generation region of the second solar cell 10B. The arrangement of the first metal interconnection wiring 7A shown in the schematic diagram of FIG. 9 corresponds, for example, to the arrangement of the first metal interconnection wiring 7A in FIGs 6 and 7, and is similar to the arrangement of the first metal interconnection wiring 7A in FIG. 8.

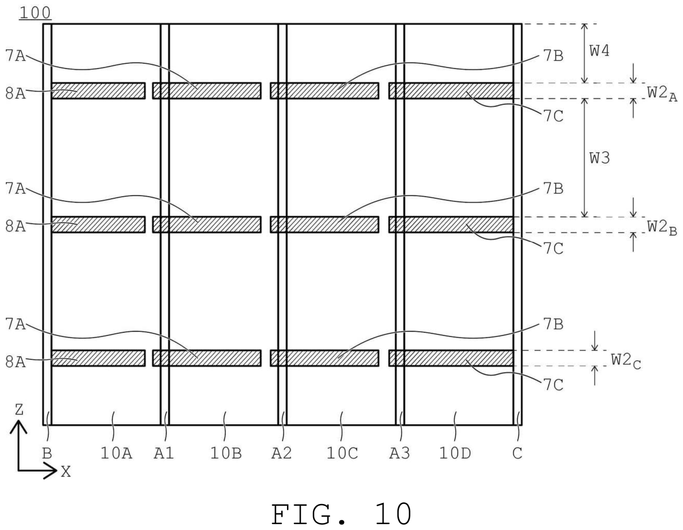

In the schematic diagram of FIG. 10, the first metal interconnection wiring 7A extends in the first direction (X direction), and the first metal extraction wiring 8A is provided on the first solar cell 10A. Multiple first metal interconnection wiring 7A are provided in the third direction (Z direction). The multiple first metal interconnection wiring 7A are spaced apart. The first metal interconnection wiring 7A is also provided on the first solar cell 10A and the second solar cell 10B, more specifically on the power-generation region of the first solar cell 10A and on the power-generation region of the second solar cell 10B. The first metal interconnection wiring 7A is not provided at both ends of the third direction (Z direction). The arrangement of the first metal interconnection wiring 7A shown in the diagram of FIG. 10 corresponds, for example, to the arrangements of the first metal interconnection wiring 7A in FIGs 2, 3, 4 and 5, and is similar to the arrangement of the first metal interconnection wiring 7A in FIG. 8.

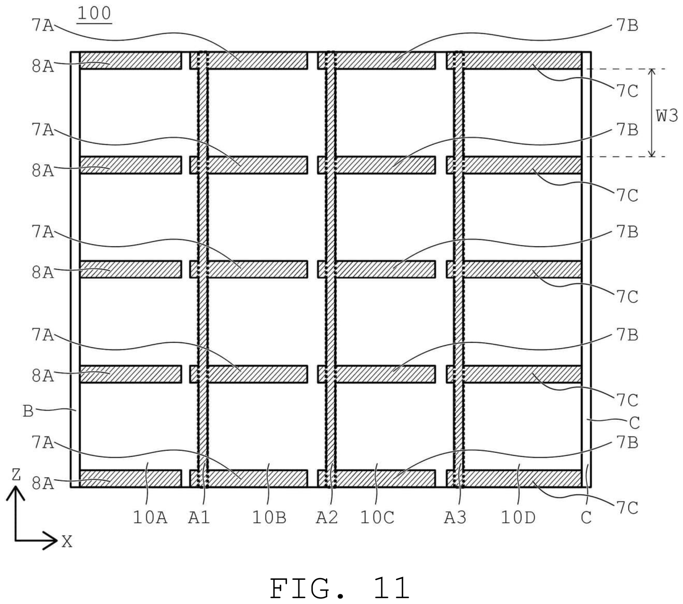

In the diagram of FIG. 11, the first metal interconnection wiring 7A extends in the first direction (X direction) and the third direction (Z direction), and the first metal extraction wiring 8A is provided on the first solar cell 10A. Multiple first metal interconnection wiring 7A are provided in the third direction (Z direction) and are connected in the third direction (Z direction) within the first joint section A1. The first metal interconnection wiring 7A is spaced apart on the first solar cell 10A and is connected in the third direction (Z direction) within the first joint section A1. The first joint section A1, the second joint section A2, and the third joint section A3 are the regions enclosed by the broken line. The first metal interconnection wiring 7A is also provided on the second solar cell 10B, more specifically on the power-generation region of the first solar cell 10A and on the power-generation region of the second solar cell 10B. The first metal interconnection wiring 7A is also provided at both ends of the third direction (Z direction). The arrangement of the first metal interconnection wiring 7A shown in the diagram of FIG. 11 corresponds, for example, to the arrangements of the first metal interconnection wiring 7A in FIGs 2, 3, 4 and 5, and is similar to the arrangement of the first metal interconnection wiring 7A in FIG. 8.

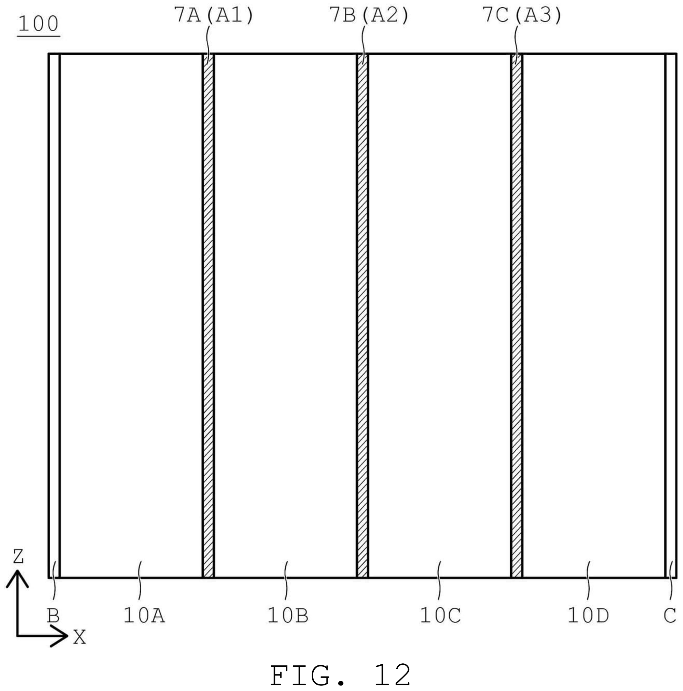

In the diagram of FIG. 12, the first metal interconnection wiring 7A extends in the third direction (Z direction). The first metal interconnection wiring 7A is not provided on the second solar cell 10B, more specifically it is not provided on the power-generation region of the first solar cell 10A nor on the power-generation region of the second solar cell 10B. The first metal interconnection wiring 7A is provided at both ends of the third direction (Z direction). The arrangement of the first metal interconnection wiring 7A shown in the diagram of FIG. 12 corresponds, for example, to the arrangements of the first metal interconnection wiring 7A in FIGs 6 and 7, and is similar to the arrangement of the first metal interconnection wiring 7A in FIG. 8.

Let W1 denote the length of the first solar cell 10A in the third direction (Z direction). Let W2 denote the width of the first metal interconnection wiring 7A provided on the power-generation region of the first solar cell 10A and on the power-generation region of the second solar cell 10B (W2 being the sum of the individual widths of the first metal interconnection wiring 7A in the third direction (Z direction) of the first solar cell 10A, i.e., W2 = W_{2A} + W_{2B} + W_{2C}). For example, it is preferable that W2 be 0.1 % or less of W1, more preferably 0.5 % or less of W1, and even more preferably 0.1 % or less of W1. By providing a thin first metal interconnection wiring 7A, the reduction of incident light on the first solar cell 10A and the second solar cell 10B can be kept very small, thereby contributing to an increase in the power generation of the solar cell module 100. When the first metal interconnection wiring 7A as shown in the configurations of FIGs 9 and 10 is provided in the solar cell module 100, the width of the first metal interconnection wiring 7A within the first joint section A1 is preferably 0.1 % or less of W1, more preferably 0.5 % or less of W1, and even more preferably 0.01 % or less of W1.

The width of a single first metal interconnection wiring 7A provided on the power-generation region of the first solar cell 10A and on the power-generation region of the second solar cell 10B is preferably 100 µm or less, preferably 0.1 µm or more and 100 µm or less, more preferably 0.5 µm or more and 30 µm or less, and further more preferably 1 µm or more and 20 µm or less. When the first metal interconnection wiring 7A as shown in the configurations of FIGs 9 and 10 is provided in the solar cell module 100, the width of the first metal interconnection wiring 7A within the first joint section A1 is preferably 0.1 µm or more and 30 µm or less, more preferably 0.5 µm or more and 20 µm or less, and further more preferably 1 µm or more and 20 µm or less.

The spacing W3 of the first metal interconnection wiring 7A provided on the power-generation region of the first solar cell 10A and on the power-generation region of the second solar cell 10B is not particularly limited, but for example, it is preferable that W3 be 0.5 mm or more and 6 mm or less, more preferably 2 mm or more and 5 mm or less, and further more preferably 2.4 mm or more and 4.6 mm or less.

The distance W4 from the first metal interconnection wiring 7A provided on the power-generation region of the first solar cell 10A and on the power-generation region of the second solar cell 10B to the end of the first solar cell 10A in the third direction (Z direction) is not particularly limited, but for example, it is preferable that W4 be 0.5 mm or more and 3 mm or less, more preferably 1 mm or more and 2.5 mm or less, and further more preferably 1.2 mm or more and 2.3 mm or less.

It is preferable that the thickness of the first metal interconnection wiring 7A be 0.1 µm or more. It is preferable that the thickness of the first metal interconnection wiring 7A be 0.1 µm or more and 100 µm or less, more preferably 0.5 µm or more and 30 µm or less, and even more preferably 1 µm or more and 20 µm or less. The thickness of the first metal interconnection wiring 7A is designed by considering the current-carrying capacity of the wiring and the like.

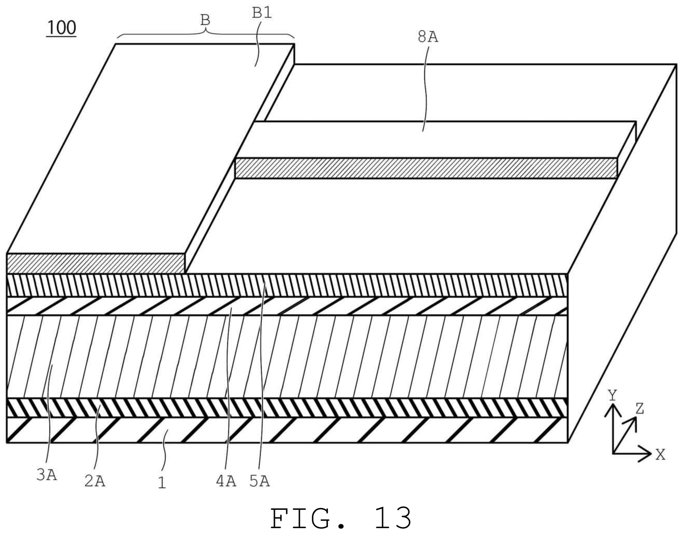

FIG. 13 to FIG. 14 show perspective schematic diagrams of the solar cell module 100. The perspective diagram of the solar cell module 100 in FIG. 13 to FIG. 14 exemplifies the connection configuration between the first solar cell 10A and the first extraction electrode B. The perspective schematic diagrams of the solar cell module 100 in FIG. 13 to FIG. 14 show the portion that includes the first extraction electrode B and the first metal extraction wiring 8A. The first extraction electrode B may be electrically connected to the first upper transparent electrode layer 5A without routing through the first metal extraction wiring 8A.

In FIG. 13, the first metal extraction wiring 8A of the solar cell module 100 is electrically connected to the first extraction electrode portion 8 at one end of the first direction of the solar cell module 100. The first extraction electrode B includes a first metal electrode layer B1. For example, the first metal electrode layer B1 is provided on the first upper transparent electrode layer 5A and/or on a side surface of the first solar cell 10A.

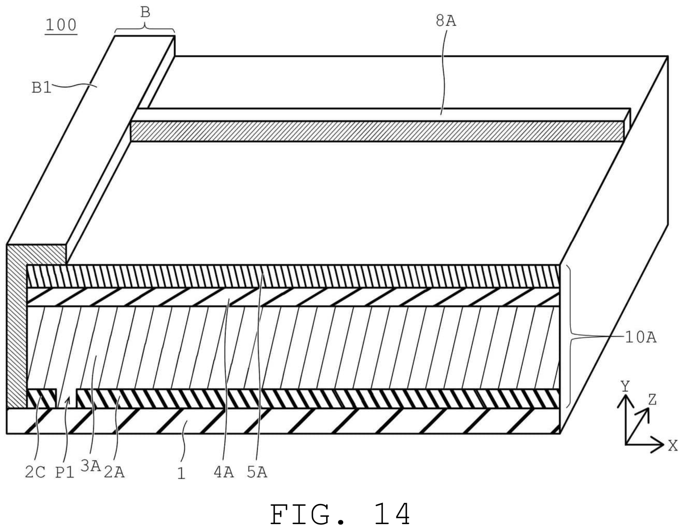

In FIG. 14, the first metal extraction wiring 8A of the solar cell module 100 is electrically connected to the first metal electrode layer B1 that is provided on an end surface of the solar cell module 100. When the first metal electrode layer B1 in FIG. 14 is electrically connected to the first lower transparent electrode layer 2A, the first isolation region P1 divides the first lower transparent electrode layer 2A, and the portion of the first lower transparent electrode layer 2A that is not electrically connected to the second upper transparent electrode layer 5B is connected to the first metal electrode layer B1.

The configuration (material, thickness, etc.) of the first metal electrode layer B1 is the same as that of the first metal interconnection wiring 7A.

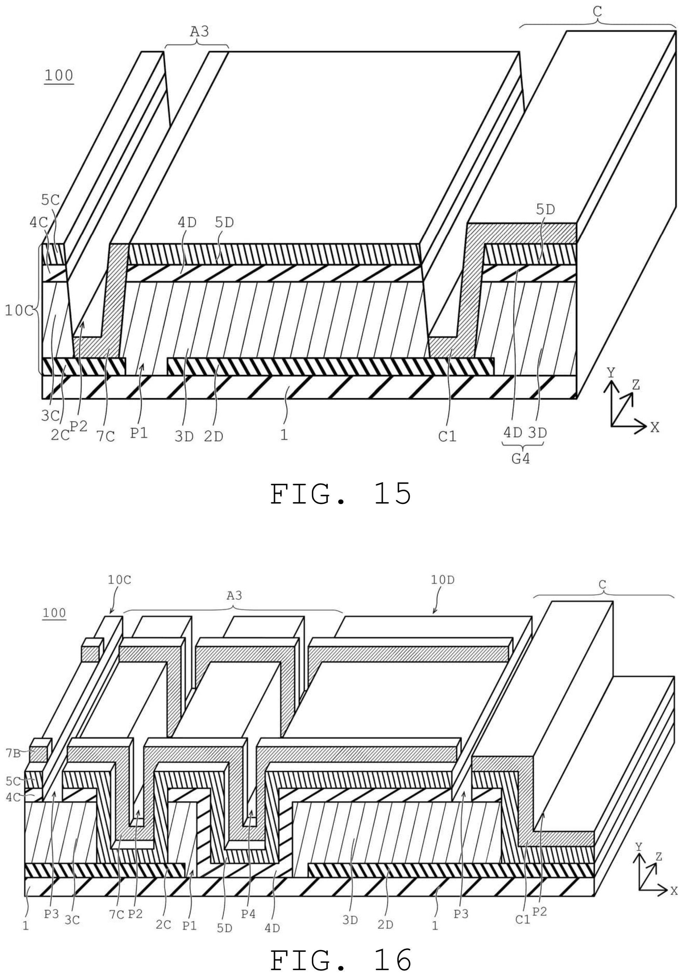

FIG. 15 to FIG. 16 show perspective schematic diagrams of the solar cell module 100. The perspective schematic diagram of the solar cell module 100 in FIG. 15 to FIG. 16 exemplifies the connection configuration between the fourth solar cell 10D and the second extraction electrode C. The perspective schematic diagram of the solar cell module 100 in FIG. 15 to FIG. 16 shows the portion that includes the third solar cell 10C, the fourth solar cell 10D, and the second extraction electrode C. The second extraction electrode C includes a second metal electrode layer C1. It is preferable that the second metal electrode layer C1 be provided in a non-power-generating region of the fourth solar cell 10D.

In FIG. 15, the second extraction electrode C of the solar cell module 100 has the second metal electrode layer C1 having a shape similar to that of the third metal wiring portion 7C, and the second metal electrode layer C1 is provided on a non-power-generating region on the fourth solar cell 10D at the end side of the solar cell module 100. The third metal wiring portion 7C may be formed on the third lower transparent electrode layer 3C on which the fourth power generation layer G4 has been removed, or on the substrate 1 on which the fourth power generation layer G4 has been removed. When the third metal wiring portion 7C and the second metal electrode layer C1 have similar shapes, the second metal electrode layer C1 can also be formed in the process of forming the third metal wiring portion 7C. The arrangement of the third metal wiring portion 7C shown in the diagram of FIG. 15 corresponds, for example, to the arrangement of the third metal wiring portion 7C in FIGS. 6, 7, 9 and 12, and is similar to the arrangement of the first metal interconnection wiring 7A in FIG. 8.

In FIG. 16, the second extraction electrode C of the solar cell module 100 has a part of the second metal electrode layer C1 having a shape similar to that of the third metal wiring portion 7C, and this part of the second metal electrode layer C1 is provided on a non-power-generating region on the fourth solar cell 10D at the end side of the solar cell module 100. The second isolation region P2 is provided on the end side of the fourth solar cell 10D, and the third isolation region P3 is used to make the portion of the second metal electrode layer C1 that is not electrically connected to the third metal wiring portion 7C into an extraction electrode. By adding an additional processing position, the second metal electrode layer C1 can also be formed in the process of forming the third metal wiring portion 7C. The arrangement of the third metal wiring portion 7C shown in the diagram of FIG. 16 corresponds, for example, to the arrangement of the third metal wiring portion 7C in FIGS. 4, 10 and 11.

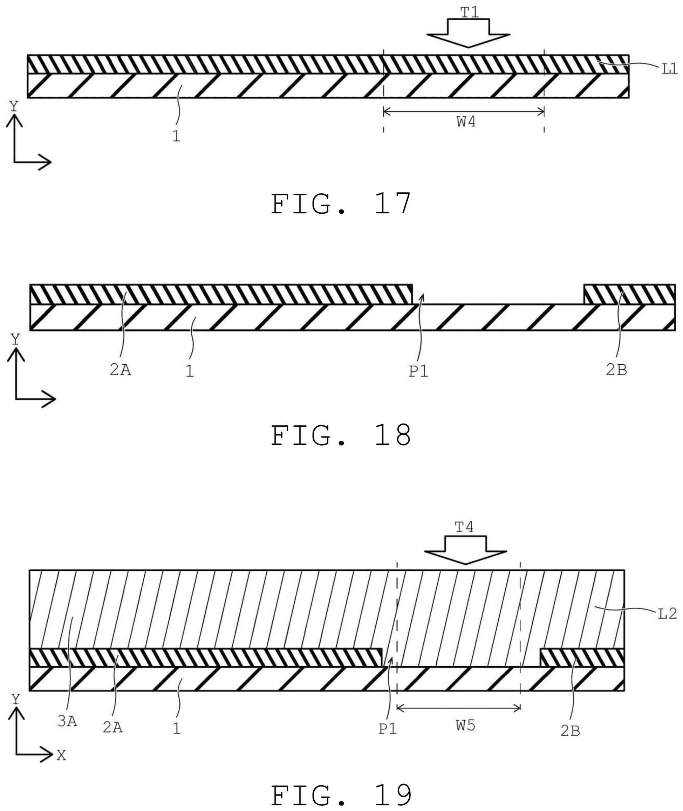

Next, a manufacturing method of the solar cell module 100 will be described briefly. Referring to schematic diagrams of FIGS. 17 to 24, the manufacturing method of the solar cell module 100 will be explained. The schematic diagrams of the manufacturing method of the solar cell module of FIGS. 17 to 24 are related to the manufacturing method of the solar cell module 100 having the configuration shown in FIG. 4.

The schematic diagram of FIG. 17 shows a member on which a first layer L1 that becomes the lower transparent electrode layer is formed on the substrate 1. Process T1 is performed on the component of FIG. 17, the first layer L1 is cut, and the first isolation region P1 shown in FIG. 18 is formed, thereby obtaining a member on which the first lower transparent electrode layer 2A and the second lower transparent electrode layer 2B shown in the diagram of FIG. 19 are provided on the substrate 1. The process T1 may be, for example, a groove-cutting operation that cuts the first layer L1. The groove-cutting of the process T1 may be performed even into a portion of the substrate 1. The width W4 denotes the groove width of the process T1. Although groove-cutting is preferred for the process T1, the process is not limited to groove-cutting and may include wet etching, dry etching, or other methods.

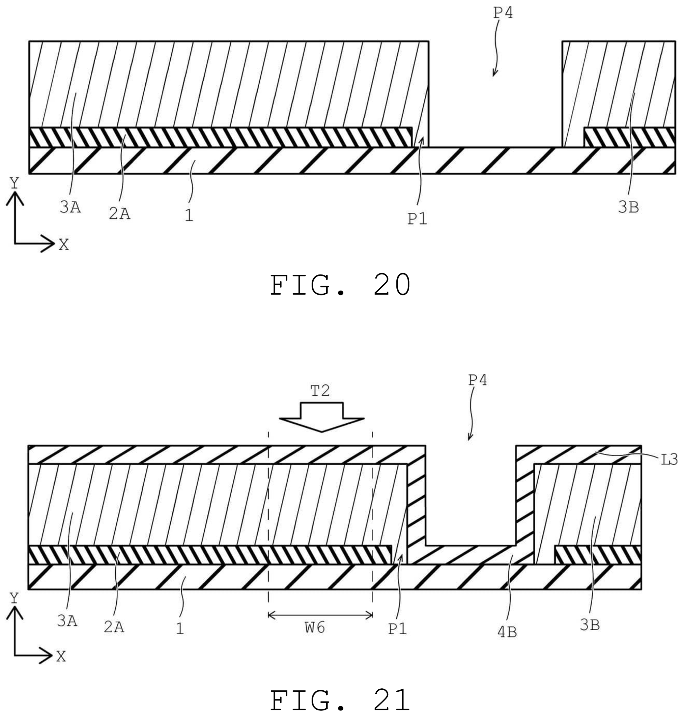

A second layer L2, which is to be the p-type light-absorbing layer, is formed on the member of FIG. 19, and process T4 is then carried out. By performing the process T4, the first p-type light-absorbing layer 3A is formed on the first lower transparent electrode layer 2A, the second p-type light-absorbing layer 3B is formed on the second lower transparent electrode layer 2B, and the fourth isolation region P4 is formed, thereby obtaining a member shown in FIG. 20. The process T4 may be, for example, a groove-cutting operation that cuts the second layer L2. In the process T4, a portion of the first lower transparent electrode layer 2A may also be removed. When the portion of the first lower transparent electrode layer 2A is removed in the process T4, a portion of the second layer L2 between the side surface of the first lower transparent electrode layer 2A on the side of the second solar cell 10B and the side surface of the second n-type layer 4B is removed; consequently, the side surface of the first lower transparent electrode layer 2A on the side of the second solar cell 10B is in direct contact with the second n-type layer 4B. The groove-cutting of the process T4 may be performed even into a portion of the substrate 1. The width W5 denotes the groove width of the process T4. Although groove-cutting is preferred for the process T4, the process is not limited to groove-cutting and may include wet etching, dry etching, or other methods.

A third layer L3, which is to be the n-type layer, is formed on the member of FIG. 20, and a member shown in FIG. 21 is obtained in which the third layer L3 is provided on the first p-type light-absorbing layer 3A, on the second p-type light-absorbing layer 3B, and on the surface exposed in the fourth isolation region P4.

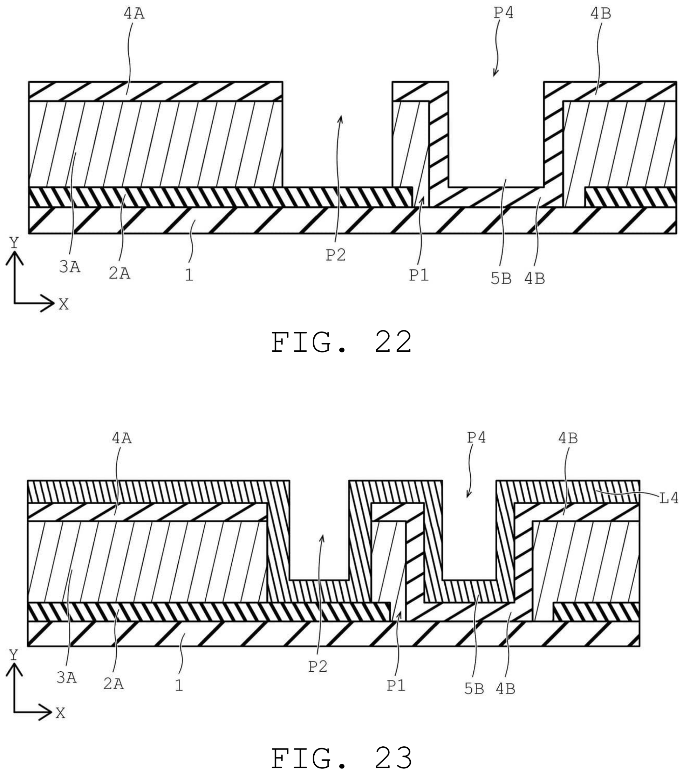

Process T2 is performed on the second layer L2 and the third layer L3 of a member of FIG. 21. By performing the process T2, the first n-type layer 4A is formed on the first p-type light-absorbing layer 3A, the second n-type layer 4B is formed on the second p-type light-absorbing layer 3B, and the second isolation region P2 is formed, thereby obtaining a member shown in FIG. 22. The process T2 may be, for example, a groove-cutting operation that cuts the second layer L2 and the third layer L3. The groove-cutting of the process T2 may be performed even into a portion of the substrate 1. The width W6 denotes the groove width of the process T2. Although groove-cutting is preferred for the process T2, the process is not limited to groove-cutting and may include wet etching, dry etching, or other methods.

A fourth layer L4, which is to be the upper transparent electrode layer, is formed on the member of FIG. 22, and a member shown in FIG. 23 is obtained in which the fourth layer L4 is provided on the first p-type light-absorbing layer 3A, on the second p-type light-absorbing layer 3B, and on the surfaces exposed in the second isolation region P2.

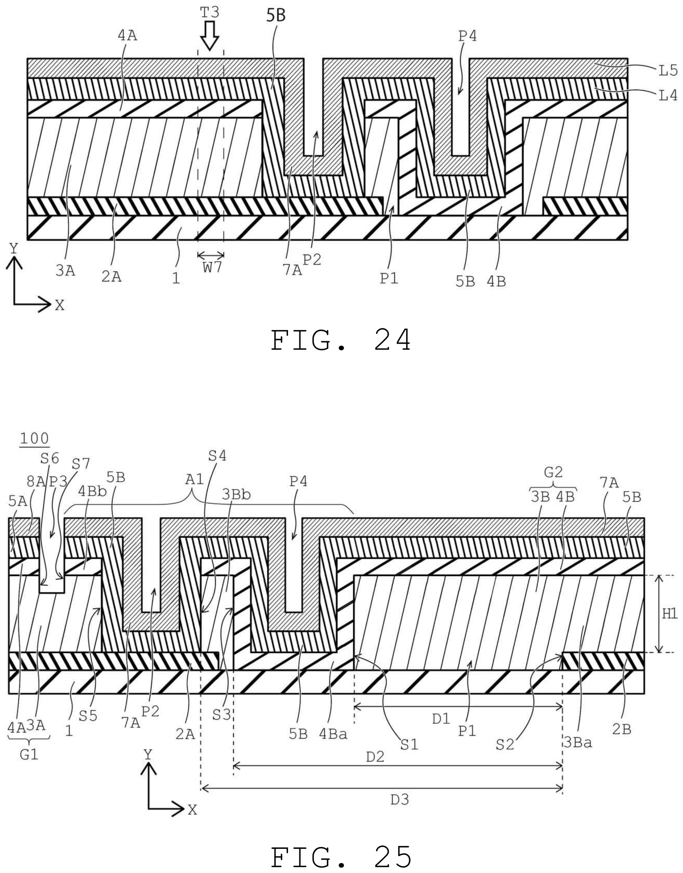

A fifth layer L5, which is to be the first metal interconnection wiring 7A and the first metal extraction wiring 8A, is formed on the member of FIG. 23, and a member shown in FIG. 24 is obtained in which the fifth layer L5 is formed on the fourth layer L4. The fifth layer L5 is formed, for example, by using a mask or similar means so that its position and shape correspond to those of the first metal interconnection wiring 7A and the first metal extraction wiring 8A (including the positions and shapes of the first extraction electrode B and the second extraction electrode portion C). The fifth layer L5 may also be formed by dispensing a conductive paste onto the fourth layer L4 with a dispenser, followed by heating to cure the conductive paste.

Process T3 is performed on the fourth layer L4 and the fifth layer L5 of the member of FIG. 24. By performing the process T3, the fourth layer L4 is divided into the first upper transparent electrode layer 5A and the second upper transparent electrode layer 5B, the fifth layer L5 is divided into the first metal interconnection wiring 7A and the first metal extraction wiring 8A, and the configuration shown in the diagram of FIG. 4 is obtained. In addition, further layers such as an antireflection film or sealing resin may be formed to obtain the solar cell module 100. The process T3 may be, for example, a groove-cutting operation that, in addition to cutting the fourth layer L4 and the fifth layer L5, partially cuts the power-generation layer. The groove-cutting of process T3 may be performed more deeply and may even extend into a portion of the substrate 1. The width W7 denotes the groove width of process T3. Although groove-cutting is preferred for process T3, the process is not limited to groove-cutting and may include wet etching, dry etching, or other methods.

Because the first metal interconnection wiring 7A is preferably formed after the power-generation layer has been formed, it is preferable that the first metal interconnection wiring 7A is not provided between the first lower transparent electrode layer 2A and the substrate 1, nor between the second lower transparent electrode layer 2B and the substrate 1.

Next, referring to a schematic cross-sectional diagram of the solar cell module 100 in FIG. 25, the first solar cell 10A, the second solar cell 10B, and the first joint section A1 are described in further detail. The schematic diagram of FIG. 25 is similar to the schematic diagram of FIG. 4.

The solar cell module 100 of FIG. 25 comprises the substrate 1; the first solar cell 10A provided on the substrate 1 and comprising the first upper transparent electrode layer 5A, the first power-generation layer G1, and the first lower transparent electrode layer 2A; the second solar cell 10B provided on the substrate 1, adjacent to the first solar cell 10A, the second solar cell 10B comprising the second upper transparent electrode layer 5B, the second power-generation layer G2, and the second lower transparent electrode layer 2B; and the first joint section A1 which electrically connects the first solar cell 10A and the second solar cell 10B. The first power-generation layer G1 comprises the first p-type light-absorbing layer 3A and the first n-type layer 4A. The second power-generation layer G2 comprises the second p-type light-absorbing layer 3B and the second n-type layer 4B. The distance D1 between the end side S2 (the side surface S2at the end ) of the second lower transparent electrode layer 2B on the first solar cell 10A side and the side surface S1 (the side surface at the end of the (primary) second p-type light-absorbing layer 3B on the first solar cell 10A side) of the second p-type light-absorbing layer 3B that is in direct contact with the second n-type layer 4B is three times or more the height H1 of the second p-type light-absorbing layer 3B. The first joint section A1 comprises the first metal interconnection wiring 7A. It is preferable that the first metal interconnection wiring 7A run partly alongside a portion of the second upper transparent electrode layer 5B and electrically connects the first lower transparent electrode layer 2A with the second upper transparent electrode layer 5B.

The description that follows, which includes the explanation of FIG. 25, concerns the first solar cell 10A, the second solar cell 10B, and the first joint section A1. This description can be substituted with an explanation of the second solar cell 10B, the third solar cell 10C, and the second joint section A2, and it can also be substituted with an explanation of the third solar cell 10C, the fourth solar cell 10D, and the third joint section A3. The explanations of the second joint section A2 for the second solar cell 10B and the third solar cell 10C, and of the third joint section A3 for the third solar cell 10C and the fourth solar cell 10D, are omitted.

In the schematic diagram of FIG. 25, the second p-type light-absorbing layer 3B of the second solar cell 10B is divided into a primary second p-type light-absorbing layer 3Ba and one or more secondary second p-type light-absorbing layers 3Bb. The primary second p-type light-absorbing layer 3Ba is the portion whose length in the first direction (X direction) is the longest among the second p-type light-absorbing layer 3B. All portions of the second p-type light-absorbing layer 3B other than the primary second p-type light-absorbing layer 3Ba are defined as secondary second p-type light-absorbing layer(s) 3Bb; multiple secondary second p-type light-absorbing layers 3Bb may exist. The second lower transparent electrode layer 2B and the second upper transparent electrode layer 5B that sandwich the primary second p-type light-absorbing layer 3Ba in the second direction (Y direction) are not short-circuited. The second lower transparent electrode layer 2B and the second upper transparent electrode layer 5B that sandwich each secondary second p-type light-absorbing layer 3Bb in the second direction (Y direction) are short-circuited. When the solar cell module 100 includes secondary second p-type light-absorbing layers 3Bb, those secondary layers are included within the first joint section A1 (not included in the second solar cell 10B (power generation region)). The primary second p-type light-absorbing layer 3Ba is part of the second solar cell 10B. The primary second p-type light-absorbing layer 3Ba and the secondary second p-type light-absorbing layers 3Bb are divided within the fourth isolation region P4 in the first joint section A1. Below, the second p-type light-absorbing layer 3B is partially distinguished as the primary second p-type light-absorbing layer 3Ba and the secondary second p-type light-absorbing layers 3Bb.

In the schematic diagram of FIG. 25, the second n-type layer 4B of the second solar cell 10B is divided into a primary second n-type layer 4Ba and one or more secondary second n-type layers 4Bb. The primary second n-type layer 4Ba is the portion whose length in the first direction (X direction) is the longest among the second n-type layer 4B. All portions of the second n-type layer 4B other than the primary second n-type layer 4Ba are defined as secondary second n-type layers 4Bb. The second n-type layer 4B is directly or electrically connected to the second upper transparent electrode layer 5B. The secondary second n-type layer 4Bb that is partially provided on the first p-type light-absorbing layer 3A, is in direct contact with the second upper transparent electrode layer 5B. The second lower transparent electrode layer 2B and the second upper transparent electrode layer 5B that sandwich the primary second n-type layer 4Ba in the second direction (Y direction) are not short-circuited. The first lower transparent electrode layer 2A and the second upper transparent electrode layer 5B that sandwich each secondary second n-type layer 4Bb in the second direction (Y direction) are short-circuited. When the solar cell module 100 includes secondary second n-type layers 4Bb, those secondary layers are included within the first joint section A1 (not included in the second solar cell 10B (power generation region)). The primary second n-type layer 4Ba extends only up a point partway along the first junction section A1. The primary second n-type layer 4Ba and the secondary second n-type layer 4Bb are separated within the second isolation region P2 in the first junction section. Below, the second n-type layer 4B is partially distinguished as the primary second n-type layer 4Ba and the secondary second n-type layers 4Bb.

The schematic diagram of FIG. 25 represents the distance D1 between (i) the end side S2 of the second lower transparent electrode layer 2B on the first solar cell 10A side (i.e., the side of the second lower transparent electrode layer 2B adjacent to the first solar cell 10A) and (ii) the side surface S1 of the primary second p-type light-absorbing layer 3Ba on the first solar cell 10A side and is in direct contact with the second n-type layer 4B. The distance D1 is a distance between the end side S2 and the side surface S1 in a direction from the end side S2 toward the first solar cell 10A. The second solar cell 10B principally generates power from light received by the second p-type light-absorbing layer 3B on the side of the third solar cell 10C, starting from the end side S2 of the second lower transparent electrode layer 2B.

From the viewpoint of preventing leakage current of the second solar cell 10B, the distance D1 is preferably three times or more the height H1 of the primary second p-type light-absorbing layer 3Ba (where H1 is the distance measured in the stacking direction of the substrate 1 and the second lower transparent electrode layer 2B (Y direction) from the surface of the second lower transparent electrode layer 2B side of the primary second p-type light-absorbing layer 3Ba to the second n-type layer 4B); more preferably four times or more; further more preferably five times or more. Reducing leakage current in the second direction (Y direction) increases Jsc and contributes to an improvement of the FF of the solar cell module 100.

The height H1 is 2 µm or more and 10 µm or less. From the same viewpoint, it is preferable that the distance D1 be 10 µm or more; more preferably 20 µm or more; and further more preferably 40 µm or more.

In order to reduce leakage current, the side surface S1 of the primary second p-type light-absorbing layer 3Ba on the first solar cell 10A side that satisfies the condition "D1 is three times or more (four times or more, five times or more) of H1", is preferably in direct contact with the second n-type layer 4B. Moreover, the entire side surface S1 of the primary second p-type light-absorbing layer 3Ba on the first solar cell 10A side that satisfies the condition "D1 is three times or more (four times or more, five times or more) of H1", is preferably in direct contact with the second n-type layer 4B. Furthermore, the entire side surface S1 of the primary second p-type light-absorbing layer 3Ba on the first solar cell 10A side that satisfies the condition "D1 is three times or more (four times or more, five times or more) of H1" and the entire surface of the primary second p-type light-absorbing layer 3Ba that faces opposite the substrate 1 extending to the end of the third solar cell 10C side of the secondary second n-type layer 4Bb from the first solar cell 10A side (the entire surface of the primary second p-type light-absorbing layer 3Ba that faces opposite the substrate 1 extending to the X direction between the first junction section A1 and the second junction section A2) are preferably in direct contact with the second n-type layer 4B.

When the distance D1 is long, the effective power-generating area of the solar cell module 100 decreases; however, intentionally making D1 long raises the FF and thereby contributes to an increase in the generated power of the solar cell module 100. Because a sufficiently long D1 provides a reducing-leakage effect, it is preferable that the length of D1 be fifteen times H1 or less; more preferably ten times H1 or less; and further more preferably eight times H1 or less. Accordingly, it is preferable that the length of D1 be three times H1 or more and fifteen times H1 or less; more preferably four times or more and 10 times or less of H1; and further more preferably five times or more and 8 times or less of H1.

It is preferable that the above advantageous requirements concerning the distance D1 and the height H1 be satisfied for all joint sections that electrically connect the solar cells in series within the solar cell module 100.

It is preferable that the above advantageous requirements concerning the distance D1 and the height H1 be satisfied for multiple adjacent joint sections that continuously electrically connect three or more solar cells in series within the solar cell module 100. The above advantageous requirements concerning the distance D1 and the height H1 are preferably satisfied for all joint sections that continuously electrically connect three or more solar cells in series within the solar cell module 100.

By depositing the p-type light-absorbing layer on the substrate 1 and the lower transparent electrode layer by sputtering, CVD, etc., a solar cell module 100 having a distance D1 that is longer than the thickness of the p-type light-absorbing layer can be obtained regardless of the opening portion of the first isolation region P1 of the lower transparent electrode layer.

The side surface S3 of the secondary second p-type light-absorbing layer 3Bb on the second solar cell 10B side is a surface that is in direct contact with the primary second n-type layer 4Ba. The distance from the side surface S3 of the secondary second p-type light-absorbing layer 3Bb on the second solar cell 10B side to the end side S2 of the second lower transparent electrode layer 2B on the first solar cell 10A side is longer than the distance D1. The side surface S3 of the secondary second p-type light-absorbing layer 3Bb on the second solar cell 10B side is the side surface generated by the fourth isolation region P4.

The second n-type layer 4B, the second upper transparent electrode layer 5B, and the first metal interconnection wiring 7A fold back between the side surface S1 of the primary second p-type light-absorbing layer 3Ba on the first solar cell 10A side and the side surface S3 of the secondary second p-type light-absorbing layer 3Bb on the second solar cell 10B side.

The schematic cross-sectional diagram of FIG. 25 represents the distance D2 between (i) the end side S2 of the second lower transparent electrode layer 2B on the first solar cell 10A side and (ii) the side surface S3 of the secondary second p-type light-absorbing layer 3Bb on the second solar cell 10B side which is in direct contact with the second n-type layer 4B. It is preferable that the distance D2 be three times or more of the height H1 of the primary second p-type light-absorbing layer 3Ba (the height of the second p-type light-absorbing layer 3B); more preferably four times or more, and further more preferably five times or more. It is preferable that the length of distance D2 is 20 times H1 or less; more preferable 15 times H1 or less; and further more preferable 10 times H1 or less.

It is preferable that the distance D2 be longer than the distance D1. It is preferable that the height H1 be 2 µm or more and 10 µm or less and the distance D2 be 31 µm or more; more preferably 36 µm or more; and further more preferable 41 µm or more.

The side surface S4 of the secondary second p-type light-absorbing layer 3Bb on the first solar cell 10A side is a surface that is not in direct contact with the second n-type layer 4B. The distance D3 from the side surface S4 of the secondary second p-type light-absorbing layer 3Bb on the first solar cell 10A side to the end side S2 of the second lower transparent electrode layer 2B on the first solar cell 10A side is longer than the distance D1. The side S4 of the secondary second p-type light-absorbing layer 3Bb on the first solar cell 10A side is the side generated by the second isolation region P2.

The first metal interconnection wiring 7A is directly connected, or is connected through the second upper transparent electrode layer 5B, to the side surface S4 of the secondary second p-type light-absorbing layer 3Bb on the first solar cell 10A side. From the viewpoint of improving the FF of the solar cell module 100, it is preferable that the distance D3 be at least 1 µm longer than the distance D1; and more preferably at least 3 µm longer than the distance D1. From the same viewpoint, it is further more preferable that the distance D3 be longer than the distance D1 and that the difference between D3 and D1 be greater than H1 µm.

The side surface S5 of the first p-type light-absorbing layer 3A on the second solar cell 10B side is a surface that is not in direct contact with the second n-type layer 4B. The distance from the side surface S5 of the first p-type light-absorbing layer 3A on the second solar cell 10B side to the end side S2 of the second lower transparent electrode layer 2B on the first solar cell 10A side is longer than the distance D1.

The second upper transparent electrode layer 5B and the first metal interconnection wiring 7A fold back between the side surface S4 of the secondary second p-type light-absorbing layer 3Bb on the first solar cell 10A side and the side surface S5 of the first p-type light-absorbing layer 3A on the second solar cell 10B side. The second n-type layer 4B does not fold back between the side surface S4 of the secondary second p-type light-absorbing layer 3Bb on the first solar cell 10A side and the side S5 of the first p-type light-absorbing layer 3A on the second solar cell 10B side.

The side surface S6 and side surface S7 of the first p-type light-absorbing layer 3A are generated by the third isolation region P3. The side surface S7 is located on the side of the second solar cell 10B, and the side surface S6 and side surface S7 face each other. Along the side surface S6 and the side surface S7, the wiring of the first upper transparent electrode layer 5A and the wiring of the second upper transparent electrode layer 5B are separated.

The side surfaces S3 through S7 may not exist, depending on the processing steps that form the second isolation region P2 to the fourth isolation region P4.

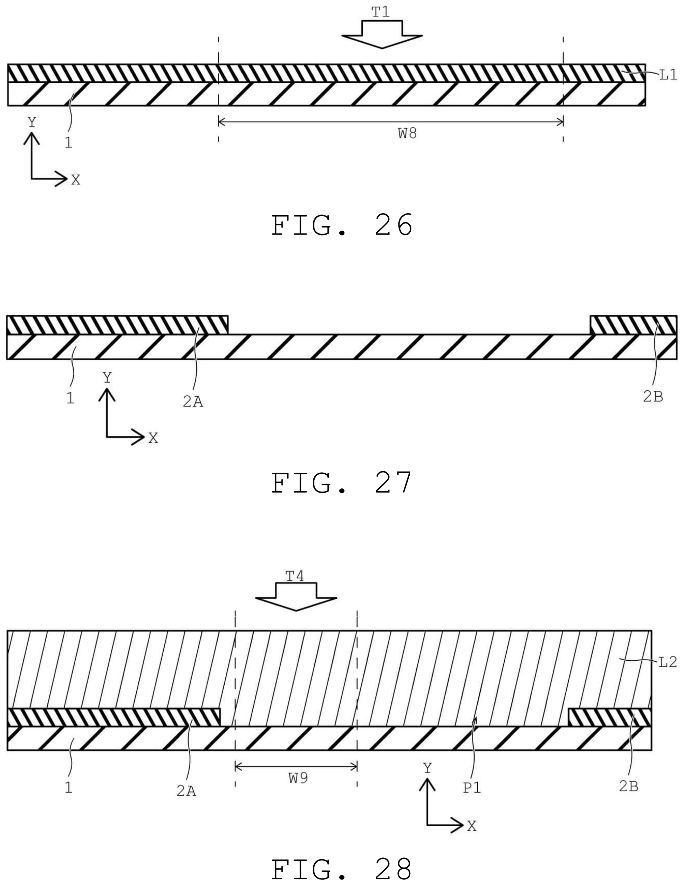

Next, the manufacturing method of solar cell module 100 of FIG. 25 is described briefly. The manufacturing method of solar cell module 100 is explained with reference to the schematic diagrams of FIG. 26 to FIG. 33. The schematic diagrams of FIG. 26 to FIG. 33 are schematic diagrams related to the manufacturing method of solar cell module 100 having the configuration of FIG. 25.

The schematic diagram of FIG. 26 shows a member on which the first layer L1 that is to be the lower transparent electrode layer has been formed on the substrate 1. The process T1 is performed on the member of FIG. 26, the first layer L1 is cut, and the first isolation region P1 is formed in FIG. 26, thereby obtaining a member shown in FIG. 27 in which the first lower transparent electrode layer 2A and the second lower transparent electrode layer 2B are provided on the substrate 1. The process T1 may be, for example, a groove-cutting operation that cuts the first layer L1. The groove-cutting of process T1 may be performed even into a portion of the substrate 1. The width W8 denotes the groove width of process T1. Although groove-cutting is preferred for process T1, the process is not limited to groove-cutting and may include wet etching, dry etching, or other methods.

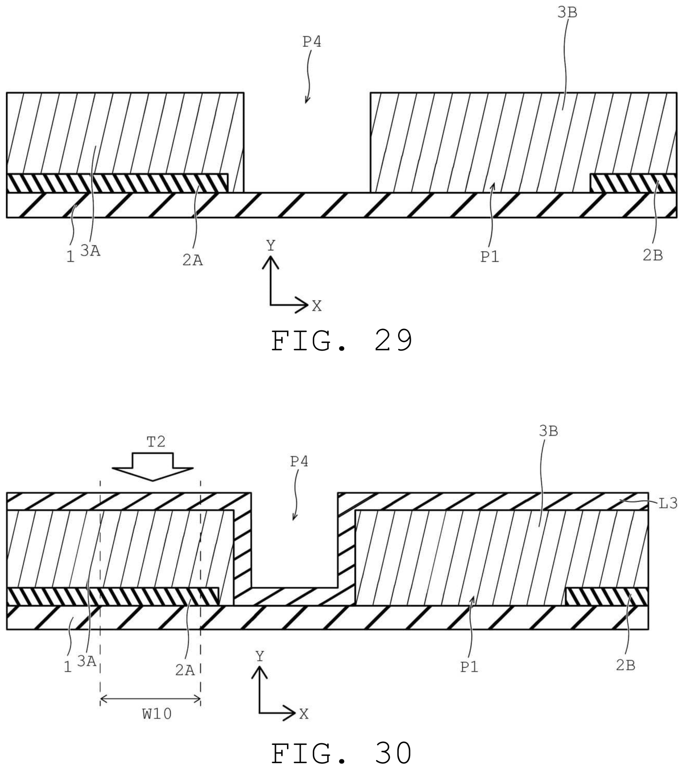

The second layer L2, which is to be the p-type light-absorbing layer, is formed on the member of FIG. 27, and the second layer L2 is provided on the first lower transparent electrode layer 2A and the second lower transparent electrode layer 2B on the substrate 1, obtaining a member of FIG. 28. Then, the process T4 is performed on the member of FIG. 28, and the first p-type light-absorbing layer 3A is formed on the first lower transparent electrode layer 2A, the second p-type light-absorbing layer 3B is formed on the second lower transparent electrode layer 2B, and the fourth isolation region P4 is formed, thereby obtaining a member shown in FIG. 29. The fourth isolation region P4 is formed so that it is highly biased toward the side of the first lower transparent electrode layer 2A (where the first solar cell 10A is provided), leaving a large portion of the second layer L2 on the side of the second lower transparent electrode layer 2B; therefore, the distance D1 can be made large. The process T4 may be, for example, a groove-cutting operation that cuts the second layer L2. The groove-cutting of process T4 may be performed even into a portion of the substrate 1. The width W9 denotes the groove width of the process T4. Although groove-cutting is preferred for the process T4, the process is not limited to groove-cutting and may include wet etching, dry etching, or other methods.

The third layer L3, which is to be the n-type layer, is formed on the member of FIG. 29, and a member shown in FIG. 30 is obtained in which the third layer L3 is provided on the first p-type light-absorbing layer 3A, on the second p-type light-absorbing layer 3B, and on the exposed surfaces in the fourth isolation region P4.

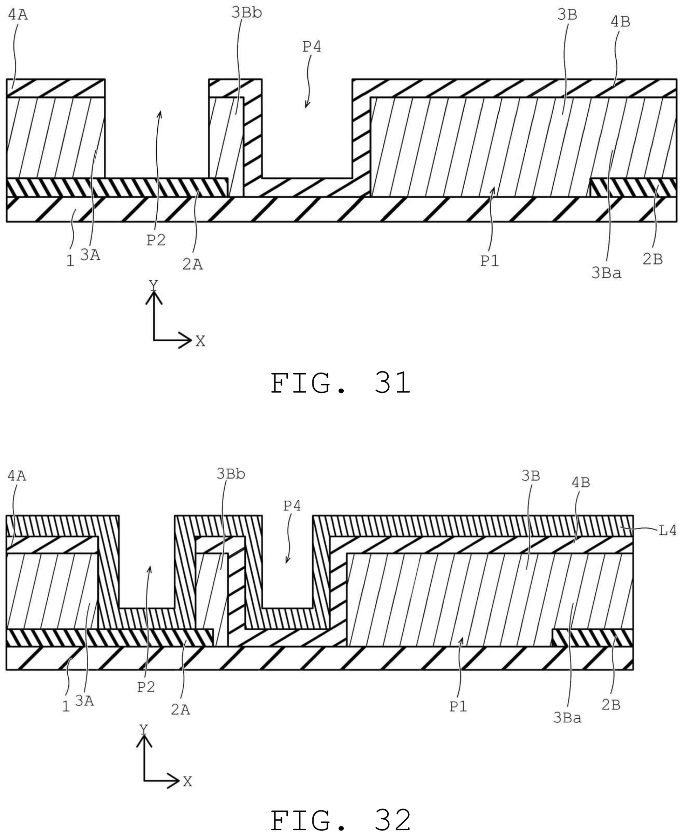

The process T2 is performed on the second layer L2 and the third layer L3 of the member of FIG. 30. By performing the process T2, the first n-type layer 4A is formed on the first p-type light-absorbing layer 3A, the second n-type layer 4B is formed on the second p-type light-absorbing layer 3B, and the second isolation region P2 is formed, thereby obtaining a member shown in FIG. 31. The process T2 may be, for example, a groove-cutting operation that cuts the second layer L2 and the third layer L3. The groove-cutting of the process T2 may be performed even into a portion of the substrate 1. The width W10 denotes the groove width of process T2. Although groove-cutting is preferred for process T2, the process is not limited to groove-cutting and may include wet etching, dry etching, or other methods.

The fourth layer L4, which is to be the upper transparent electrode layer, is formed on the member of FIG. 31, and a member shown in FIG. 32 is obtained in which the fourth layer L4 is provided on the first p-type light-absorbing layer 3A, on the second p-type light-absorbing layer 3B, and on the exposed surfaces in the second isolation region P2.

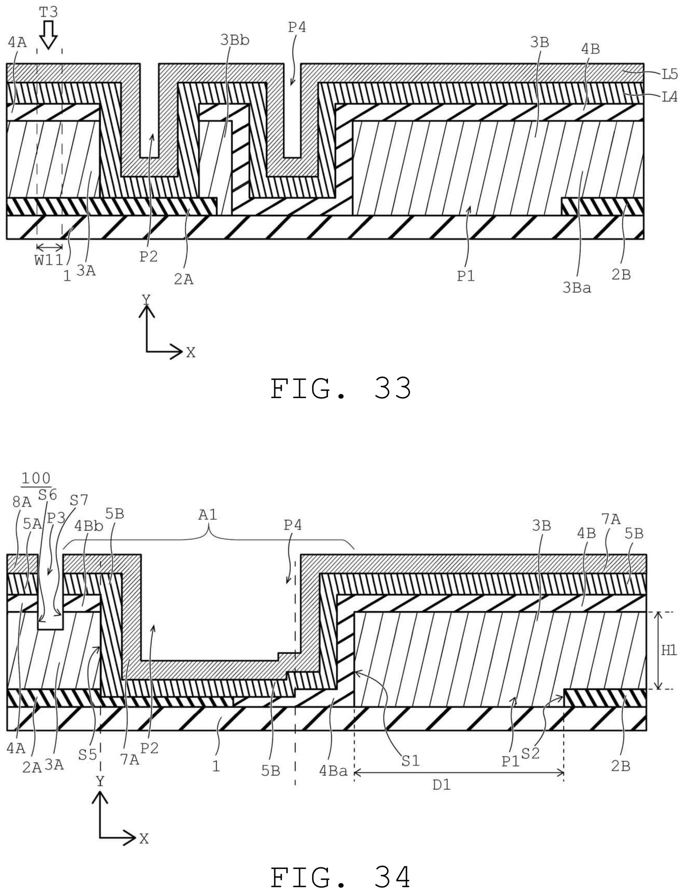

A fifth layer L5, which is to be the first metal interconnection wiring 7A and the first metal extraction wiring 8A, is formed on the member of FIG. 32, and a member shown in FIG. 33 is obtained in which the fifth layer L5 is formed on the fourth layer L4. The fifth layer L5 may be formed, for example, by using a mask or similar means so that its position and shape correspond to those of the first metal interconnection wiring 7A and the first metal extraction wiring 8A (including the positions and shapes of the first extraction electrode part B and the second extraction electrode C). The fifth layer L5 may also be formed by dispensing a conductive paste onto the fourth layer L4 with a dispenser, followed by heating to cure the conductive paste.

The processing T3 is performed on the fourth layer L4 and the fifth layer L5 of the member of FIG. 33. By performing the process T3, the fourth layer L4 is divided into the first upper transparent electrode layer 5A and the second upper transparent electrode layer 5B, and the fifth layer L5 is divided into the first metal interconnection wiring 7A and the first metal extraction wiring 8A, thereby obtaining the configuration of the schematic diagram of FIG. 25. In addition, for example, an antireflection film or a sealing resin may be further formed to obtain solar cell module 100. The process T3 may be, for example, a groove-cutting operation that partially cuts the power-generating layers in addition to the fourth layer L4 and the fifth layer L5. In solar cell module 100 of FIG. 25, the third isolation region P3 reaches at least partially into the first p-type light-absorbing layer 3A. The groove-cutting of the process T3 may be performed more deeply and may be performed even into a portion of the substrate 1. The width W11 denotes the groove width of the process T3. Although groove-cutting is preferred for the process T3, the process is not limited to groove-cutting and may include wet etching, dry etching, or other methods.

FIG. 34 is a schematic cross-sectional diagram showing solar cell module 100. The solar cell module 100 of FIG. 34 is a variation example of the solar cell module 100 of FIG. 25. The solar cell module 100 of FIG. 34 differs from that of FIG. 25 in that the second isolation region P2 and the fourth isolation region P4 are connected. The preferable requirements for H1, D1, D2 and D3 of the solar cell module 100 of FIG. 34 are common with the preferable requirements for H1, D1, D2 and D3 of the solar cell module 100 of FIG. 25. The solar cell module 100 of FIG. 34 also reduces leakage current and contributes to an improvement of the FF of the solar cell module.

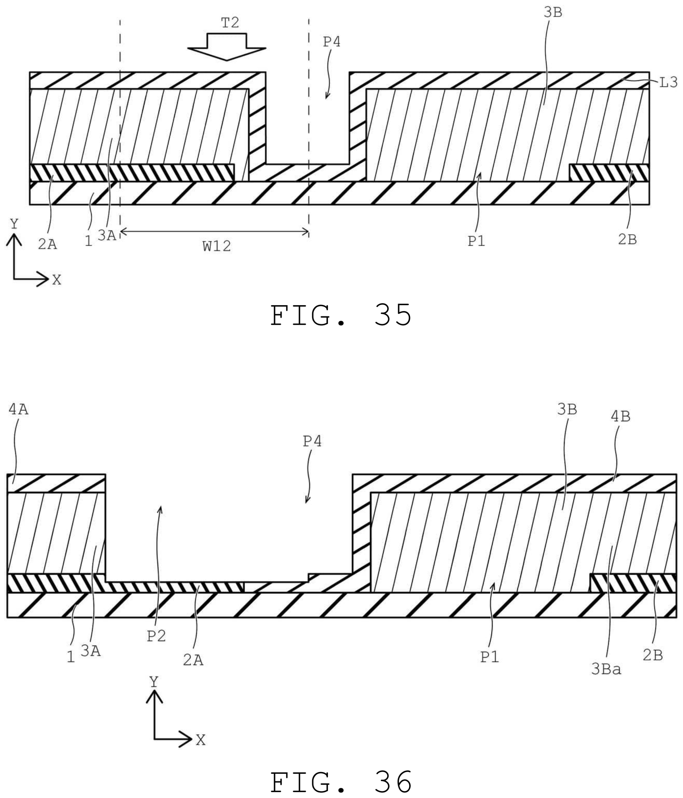

Next, the manufacturing method of the solar cell module 100 shown in FIG. 34 is described briefly. The manufacturing method of the solar cell module 100 shown in FIG. 34 is explained with reference to the schematic diagrams of FIG. 26 to FIG. 33 and the schematic diagrams of FIG. 35 and FIG. 36. Except for the process T2, the manufacturing method of the solar cell module 100 shown in FIG. 34 is common with the manufacturing method of the solar cell module 100 shown in FIG. 25.

Following the flow of the schematic diagrams from FIG. 26 through FIG. 28, a member shown in FIG. 29 is obtained. On the member of FIG. 29, the third layer L3 which is to be the n-type layer, is formed, and the third layer L3 is provided on the first p-type light-absorbing layer 3A, on the second p-type light-absorbing layer 3B, and on the surfaces exposed in the fourth isolation region P4, thereby obtaining the member shown in FIG. 35.

The process T2 is performed on the second layer L2 and the third layer L3 of a member shown in FIG. 35. The second isolation region P2 that is formed in the process T2, becomes connected with the fourth isolation region P4. By performing the process T2, the first n-type layer 4A is provided on the first p-type light-absorbing layer 3A, the second n-type layer 4B is provided on the second p-type light-absorbing layer 3B, and the second isolation region P2 is formed, thereby obtaining a member shown in FIG. 36. The width W12 denotes the groove width of the process T2. In the process T2, the position of the cut is adjusted so that a portion of the fourth isolation region P4 (the third layer L3 that is provided on the side of the first solar cell 10A of the second p-type light-absorbing layer 3B) remains.

The fourth layer L4 and the fifth layer L5 are formed on the member of FIG. 36 by the method described with respect to the schematic diagrams of FIG. 32 and FIG. 33, and the process T3 is performed, thereby obtaining the solar cell module 100 shown in FIG. 34.

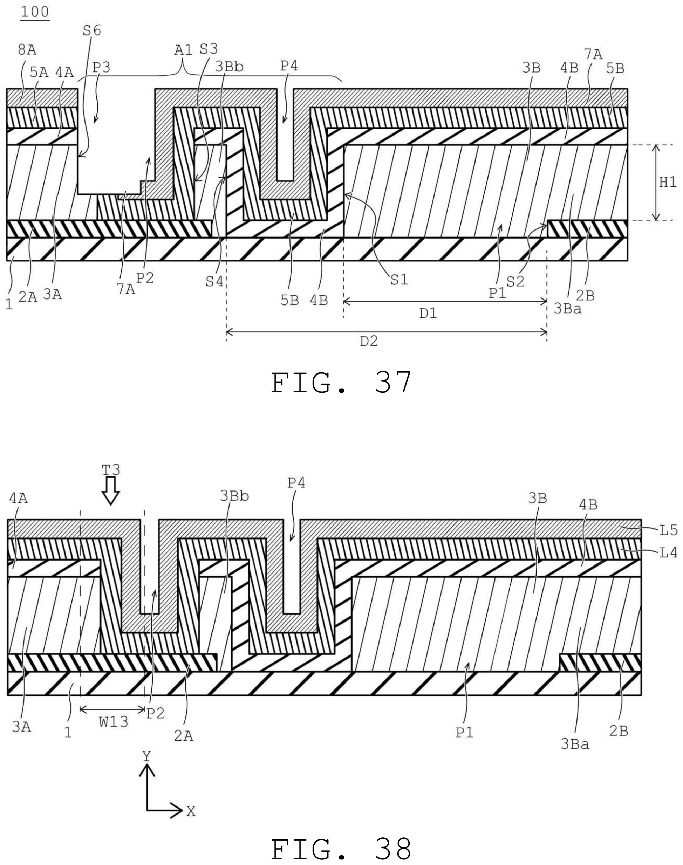

A schematic cross-sectional diagram of FIG. 37 shows the solar cell module 100. The solar cell module 100 of FIG. 37 is a variation example of the solar cell module 100 of FIG. 25. The solar cell module 100 of FIG. 37 differs from the solar cell module 100 of FIG. 25 in that the second isolation region P2 and the third isolation region P3 are connected. The preferable requirements for H1, D1, D2 and D3 of the solar cell module 100 of FIG. 37 are common with the preferable requirements for H1, D1, D2 and D3 of the solar cell module 100 of FIG. 25. The solar cell module 100 of FIG. 37 also reduces leakage current and contributes to an improvement of the FF of the solar cell module 100.

Next, the manufacturing method of the solar cell module 100 shown in FIG. 37 will be described briefly. The manufacturing method of the solar cell module 100 shown in FIG. 34 is explained with reference to the schematic diagrams of FIG. 26 to FIG. 33 as well as the schematic diagram of FIG. 38. Except for process T3, the manufacturing method of the solar cell module 100 shown in FIG. 37 is common with the manufacturing method of the solar cell module 100 shown in FIG. 25.

Following the flow of the schematic diagrams from FIG. 26 to FIG. 31, the member shown in FIG. 32 is obtained. On the member of FIG. 32, the fifth layer L5 which is to be the first metal interconnection wiring 7A and the first metal extraction wiring 8A, is formed, thereby obtaining a member shown in FIG. 38 in which the fifth layer L5 is formed on the fourth layer L4.

The process T3 is performed on the fourth layer L4 and the fifth layer L5 of the member shown in FIG. 38. By performing the process T3, the fourth layer L4 is divided into the first upper transparent electrode layer 5A and the second upper transparent electrode layer 5B, and the fifth layer L5 is divided into the first metal interconnection wiring 7A and the first metal extraction wiring 8A, thereby obtaining the solar cell module 100 having the configuration shown in the schematic diagram of FIG. 37. In the process T3, the third isolation region P3 is connected with the second isolation region P2. The width W13 denotes the groove width of the process T3. The process T3, for example, removes the portion on the side surface of the first p-type light-absorbing layer 3A on the second solar cell 10B side, the portion of the fourth layer L4 that is in direct contact with the side surface of the first p-type light-absorbing layer 3A on the second solar cell 10B side, and the portion of the fifth layer L5 that is provided along the side of the fourth layer L4. The process T3 is carried out so that the electrical connections between the first lower transparent electrode layer 2A and the second upper transparent electrode layer 5B within the second isolation region P2, between the first lower transparent electrode layer 2A and the first metal interconnection wiring 7A, and between the second upper transparent electrode layer 5B and the first metal interconnection wiring 7A, are not interrupted, thereby preserving the stacked structure of the first lower transparent electrode layer 2A, the second upper transparent electrode layer 5B, and the first metal interconnection wiring 7A.

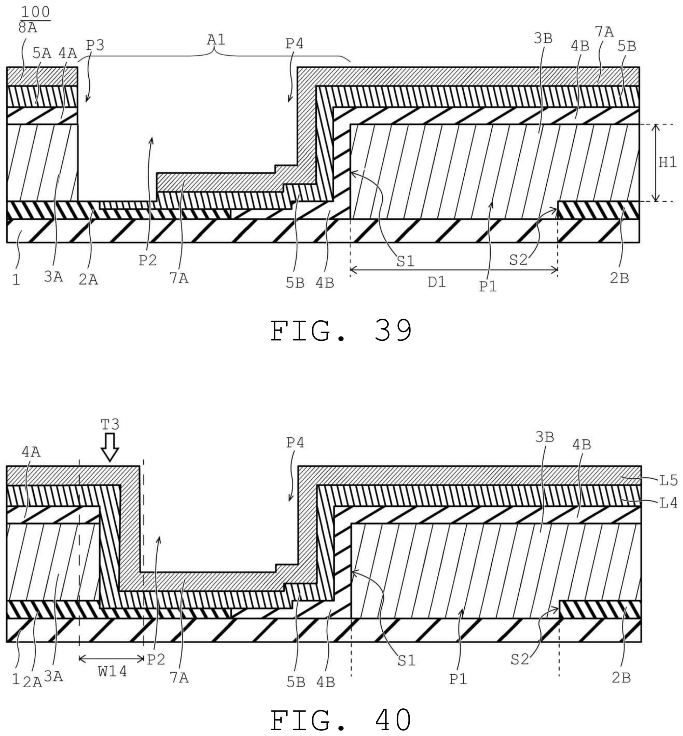

A schematic cross-sectional diagram of FIG. 39 shows the solar cell module 100. The solar cell module 100 of FIG. 39 is a variation example of the solar cell module 100 of FIG. 25 and of the solar cell module 100 of FIG. 34. The solar cell module 100 of FIG. 39 differs from the solar cell module 100 of FIG. 25 in that the second isolation region P2, the third isolation region P3, and the fourth isolation region P4 are connected. The preferable requirements for H1 and D1 of the solar cell module 100 of FIG. 39 are common with the preferable requirements for H1 and D1 of the solar cell module 100 of FIG. 25. The solar cell module 100 of FIG. 39 also reduces leakage current and contributes to an improvement of the FF of the solar cell module 100.

Next, the manufacturing method of the solar cell module 100 shown in FIG. 39 is described briefly. The manufacturing method of the solar cell module 100 shown in FIG. 39 is explained with reference to the schematic diagrams of FIG. 26 to FIG. 33 and the schematic diagrams of FIG. 35, FIG. 36, and FIG. 40. Except for the process T2 and the process T3, the manufacturing method of the solar cell module 100 shown in FIG. 39 is common with the manufacturing method of the solar cell module 100 shown in FIG. 25.

Following the flow of the schematic diagrams from FIG. 26 to FIG. 28, the member shown in FIG. 29 is obtained. On the member of FIG. 29, the third layer L3, which is to be the n-type layer, is formed, and the third layer L3 is provided on the first p-type light-absorbing layer 3A, on the second p-type light-absorbing layer 3B, and on the surfaces exposed in the fourth isolation region P4, thereby obtaining the member shown in FIG. 35.

The process T2 is performed on the second layer L2 and the third layer L3 of the member shown in FIG. 35. As a result of the process T2, the second isolation region P2 that is formed becomes connected with the fourth isolation region P4. By performing the process T2, the first n-type layer 4A is formed on the first p-type light-absorbing layer 3A, the second n-type layer 4B is formed on the second p-type light-absorbing layer 3B, and the second isolation region P2 is formed, thereby obtaining the member shown in FIG. 36. The fourth layer L4 and the fifth layer L5 are then formed on the member of FIG. 36, thereby obtaining a member shown in FIG. 40.

The process T3 is performed on the fourth layer L4 and the fifth layer L5 of the member shown in FIG. 40. By performing the process T3, the fourth layer L4 is divided into the first upper transparent electrode layer 5A and the second upper transparent electrode layer 5B, and the fifth layer L5 is divided into the first metal interconnection wiring 7A and the first metal extraction wiring 8A, thereby obtaining the solar cell module 100 having the configuration shown in the schematic diagram of FIG. 39. In the process T3, the third isolation region P3, which is already connected with the fourth isolation region P4, is connected with the second isolation region P2. The width W14 denotes the groove width of the process T3. The process T3, for example, removes the portion on the side surface of the first p-type light-absorbing layer 3A on the second solar cell 10B side, the portion of the fourth layer L4 where is in direct contact with the side surface of the first p-type light-absorbing layer 3A on the second solar cell 10B side, and the portion of the fifth layer L5 that is provided along the side of the fourth layer L4. The process T3 is carried out so that the electrical connections between the second isolation region P2 and the fourth isolation region P4 within the first lower transparent electrode layer 2A and the second upper transparent electrode layer 5B, between the first lower transparent electrode layer 2A and the first metal interconnection wiring 7A, and between the second upper transparent electrode layer 5B and the first metal interconnection wiring 7A are not interrupted, thereby preserving the stacked structure of the first lower transparent electrode layer 2A, the second upper transparent electrode layer 5B, and the first metal interconnection wiring 7A.

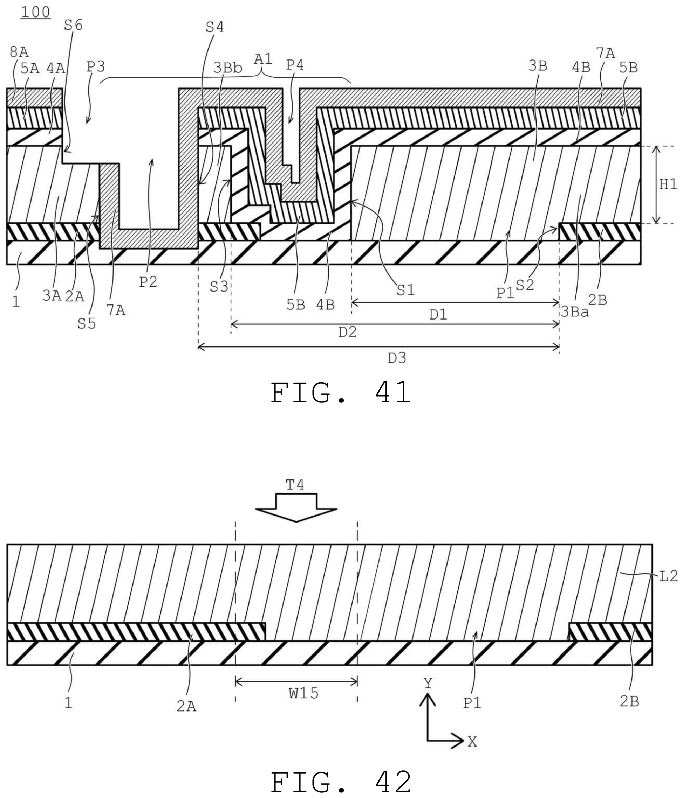

A schematic cross-sectional diagram of FIG. 41 shows the solar cell module 100. The solar cell module 100 of FIG. 41 is a variation example of the solar cell module 100 of FIG. 25. The solar cell module 100 of FIG. 41 differs from the solar cell module 100 of FIG. 25 in that, within the fourth isolation region P4, the second n-type layer 4B, the second upper transparent electrode layer 5B, and the first metal interconnection wiring 7A are partially formed on the first lower transparent electrode layer 2A; the second isolation region P2 penetrates the first lower transparent electrode layer 2A, and the first metal interconnection wiring 7A is provided in the opened portion of the first lower transparent electrode layer 2A; and the second isolation region P2 is connected with the third isolation region P4. The preferable requirements for H1, D1, D2, and D3 of the solar cell module 100 of FIG. 41 are common with the preferable requirements for H1, D1, D2, and D3 of the solar cell module 100 of FIG. 25. The solar cell module 100 of FIG. 37 also reduces leakage current and contributes to an improvement of the FF of the solar cell module 100.

Next, the manufacturing method of the solar cell module 100 shown in FIG. 41 is described briefly. The manufacturing method of the solar cell module 100 shown in FIG. 41 is explained with reference to the schematic diagrams from FIG. 26 to FIG. 30 and the schematic diagrams of FIG. 38 and FIG. 42 to FIG. 45. Except for process T2' and the process T3, the manufacturing method of the solar cell module 100 shown in FIG. 41 is common with the manufacturing method of the solar cell module 100 shown in FIG. 25.

Following the flow of the schematic diagrams from FIG. 26 to FIG. 28, a member shown in FIG. 41 is obtained. On the member of FIG. 41, the process T4 is performed to form the fourth isolation region P4. In the process T4, the portion of the first lower transparent electrode layer 2A is also removed.

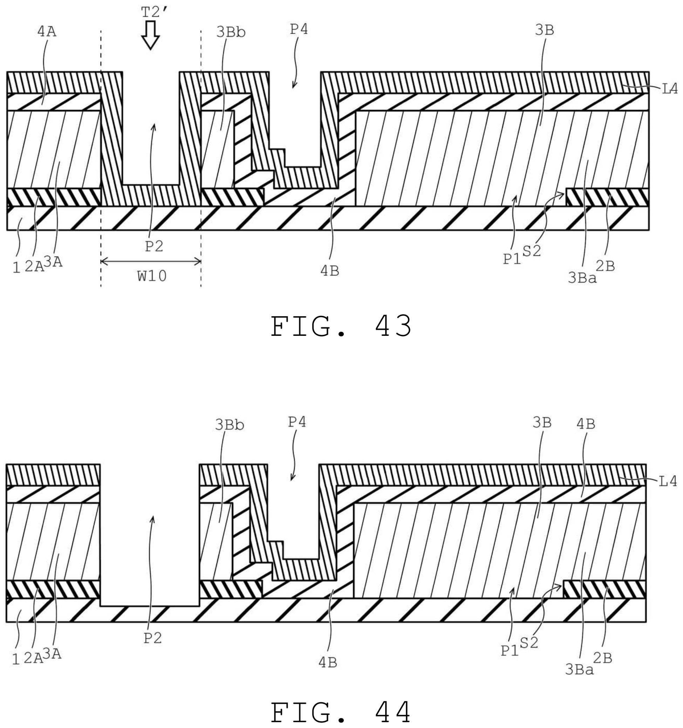

Subsequently, the second isolation region P2 is formed according to the flow of the schematic diagrams from FIG. 30 to FIG. 32. Then, the fourth layer L4 is formed on the member in which the second isolation region P2 has been formed, thereby obtaining a member shown in FIG. 43. The process T2 (T2') is performed again on the member of FIG. 43, removing the fourth layer L4 within the second isolation region P2 and thereby obtaining a member shown in FIG. 44. In the further application of the process T2 (T2'), the portion of the first lower transparent electrode layer 2A may be penetrated to form an opening, or the portion of the substrate 1 may be removed. The width W10 of this subsequent (second) process T2 (T2') may be the same as the width of the first process T2, or it may be narrower or wider than the W10 of the first process T2.

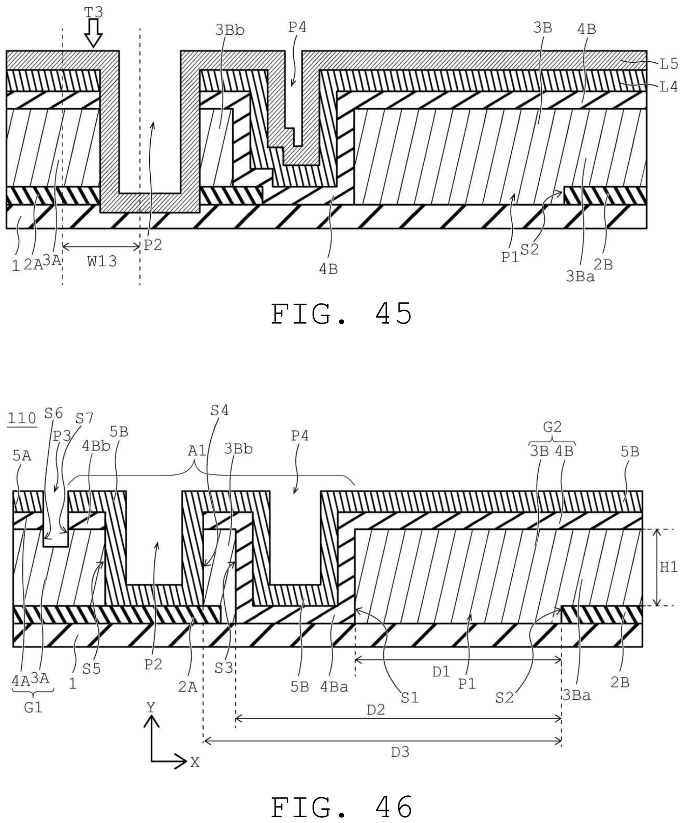

The fifth layer L5 is formed on the re-formed second isolation region P2 and on the fourth layer L4 within the member of FIG. 44, thereby obtaining a member shown in FIG. 45. On the member of FIG. 45, the third isolation region P3 is formed according to the flow of the schematic diagram of FIG. 38, thereby obtaining the solar cell module 100 of FIG. 41. The first metal interconnection wiring 7A directly connects the end surface of the first lower transparent electrode layer 2A with the end surface of the second upper transparent electrode layer 5B, thereby reducing the wiring resistance between the solar cells.

It is permissible that within the solar cell module 100 the configurations of FIG. 25, FIG. 25, FIG. 34, FIG. 37, FIG. 39 and FIG. 41 are mixed.

A schematic cross-sectional diagram of FIG. 46 shows the solar cell module 100. The solar cell module 100 of FIG. 46 is a variation example of the solar cell module 100 of FIG. 25, FIG. 34, FIG. 37 and FIG. 39. The solar cell module 110 of FIG. 46 lacks the first metal interconnection wiring 7A. Because the solar cell module 110 of FIG. 46 without the first metal interconnection wiring 7A satisfies the preferable requirement for distance D1, it contributes to an improvement of the FF of the solar cell module 100. By providing the first metal interconnection wiring 7A in the solar cell module 110 of FIG. 46, the wiring resistance is effectively reduced, thereby contributing to an improvement of the FF of the solar cell module 110.

### (SECOND EMBODIMENT)

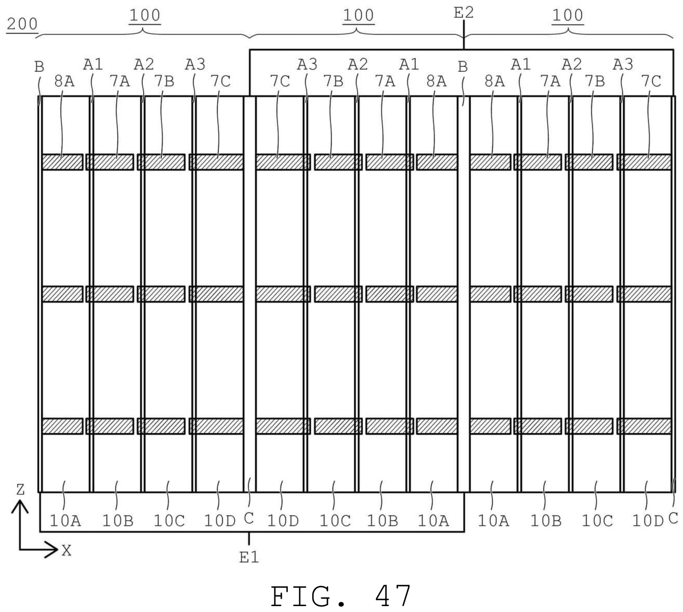

A second embodiment relates to a solar cell module. A schematic top-view diagram of a solar cell module 200 of the second embodiment is shown in FIG. 47. The solar cell module 200 includes a configuration in which a plurality of the solar cell modules 100 of the first embodiment are arranged side by side. Adjacent the solar cell modules 100 are mirrored left to right in the drawings and are connected by the first extraction electrode B or the second extraction electrode C. The first extraction electrode members B having the same electrical polarity are connected and become a first electrode E1 of the solar cell module 200. The second extraction electrode parts C having the same electrical polarity are connected and become a second electrode E2 of the solar cell module 200.

### (THIRD EMBODIMENT)

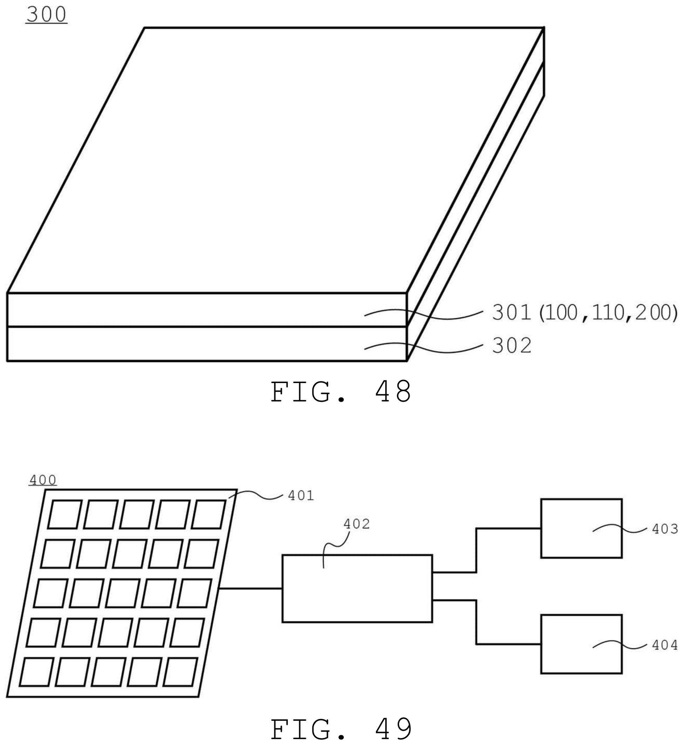

A third embodiment relates to a multi-junction solar-cell module. A schematic diagram of a multi-junction solar cell module 300 of the third embodiment is shown in FIG. 48. The multi-junction solar-cell module 300 of FIG. 48 is a solar cell module formed by stacking the first solar cell module 301 and the second solar cell module 302. The first solar-cell module 301 is positioned on the light-incident side. The first solar-cell module 301 may employ the solar cell module 100 (110) of the first embodiment or the solar cell module 200 of the second embodiment. The second solar cell module 302 includes a solar cell having a light-absorbing layer whose band-gap is narrower than that of the light-absorbing layer of the first solar cell module 301; for example, a Si solar cell may be used.

The first solar cell module 301 can be installed on the second solar cell module 302 which has already been installed by using a fixing member or similar means, thereby obtaining the multi-junction solar cell module 300.

### (FOURTH EMBODIMENT)

A fourth embodiment relates to a photovoltaic power generation system. The solar cell modules of the first through third embodiments can be used as photovoltaic power generators in the photovoltaic power generation system of the fourth embodiment. The solar power generation system of the embodiments comprises a solar-cell module that generates electricity, a convertor converting the generated electricity, and either a storage storing the generated electricity or a load consuming the generated electricity. A configuration diagram of the photovoltaic power generation system 400 of the embodiments is shown in FIG. 49. The photovoltaic power generation system 400 of FIG. 49 includes a solar-cell module 401 (100 ~ 300), a converter 402, a storage battery 403, and a load 404. Either the storage battery 403 or the load 404 may be omitted. The load 404 may be configured to also use the electrical energy stored in the storage battery 403. The converter 402 is a device that includes circuits or elements for power conversion such as voltage conversion or DC-AC/AC-DC/AC-AC conversion; examples are DC-DC converters, DC-AC converters, and AC-AC converters. The configuration of the converter 402 may be selected as appropriate for the generated voltage, the storage battery 403, and the load 404.

The solar cells included in the solar cell module 401 generate electricity, which is converted by the converter 402 and then either stored in the storage battery 403 or consumed by the load 404. It is preferable to provide the solar cell module 401 with a solar-tracking drive device that always points the solar-cell module 401 toward the sun, a light-concentrating element that concentrates sunlight, or other devices that improve the generation efficiency. As a load 404, an electrolysis apparatus for water electrolysis, CO₂ electrolysis, ammonia electrolysis, or ammonia synthesis may be used.

The photovoltaic power generation system 400 may be employed for real-estate such as residences, commercial facilities, or factories, as well as for movable assets such as vehicles, aircraft, or electronic equipment. By using solar cells having superior conversion efficiency in the solar-cell modules, an increase in the generated power can be expected.

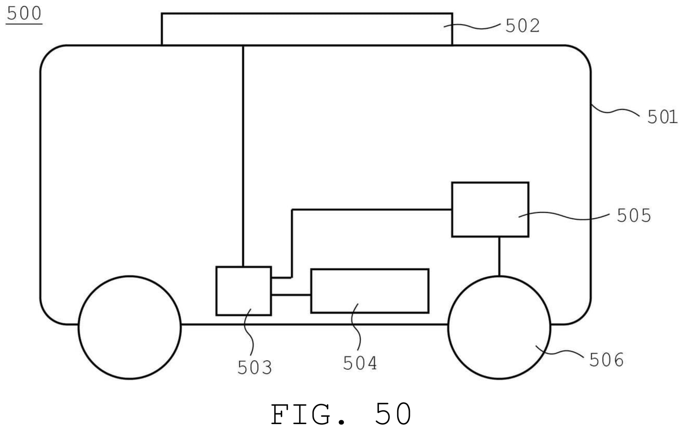

An example of using the photovoltaic power generation system 400 is a vehicle. A conceptual configuration diagram of a vehicle 500 is shown in FIG. 50. The vehicle 500 comprises a body 501, a solar cell module 502, a power-conversion device 503, a storage battery 504, a motor 505, and tires (wheels) 506. The electric power generated by the solar cell module 502, which is mounted on the upper portion of the body 501, is converted by the power-conversion device 503 and is either stored in the storage battery 504 or consumed by the motor 505 and other loads. By using the power supplied from the solar cell module 502 or the storage battery 504, the motor 505 rotates the tires 506, thereby propelling the vehicle 500. When a transparent solar cell module 502 is adopted, it is also preferable to use the solar cell module 502 as a power-generating window on the side surfaces of the body 501 in addition to the upper surface.

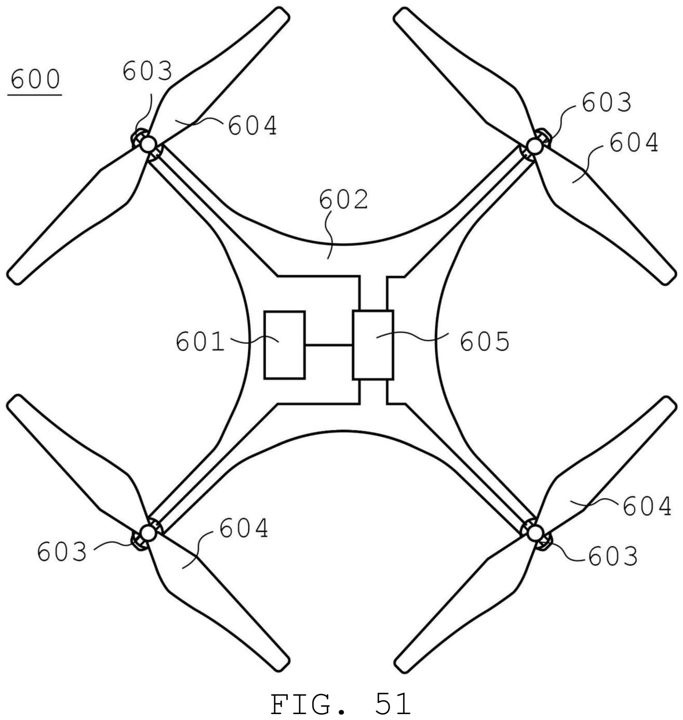

An example of using the photovoltaic power generation system 400 is a drone (quadcopter). The drone uses the solar cell module 401 as its solar cell module. The configuration of a drone 600 according to the present embodiments is briefly described with reference to the schematic diagram of the drone 600 shown in FIG. 51. The drone 600 includes a solar cell module 601, a frame 602, a motor 603, rotors 604, and a control unit 605. The solar cell module 601, the motor 603, the rotors 604, and the control unit 605 are mounted on the frame 602. The control unit 605 converts and/or regulates the power output from the solar cell module 601. The motor 603 uses the power output from the solar-cell module 601 to rotate the rotors 604. By providing the solar cell module 601 in the configuration of the drone 600, a drone capable of flying with a larger amount of available power can be provided.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Some elements are expressed only by element symbols thereof.

## Claims

1. A solar cell module (100) comprising:
a substrate (1);
a first solar cell (10A) provided on the substrate (1), the first solar cell (10A) comprising a first upper transparent electrode layer (5A), a first power generation layer (G1), and a first lower transparent electrode layer (2A);
a second solar cell (10B) provided on the substrate (1), adjacent to the first solar cell (10A), the second solar cell (10B) comprising a second upper transparent electrode layer (5B), a second power generation layer (G2), and a second lower transparent electrode layer (2B); and
a first metal interconnection wiring (7A) that electrically connects the first solar cell (10A) and the second solar cell (10B), wherein
the first upper transparent electrode layer (5A) and the second upper transparent electrode layer (5B) are provided on the light incident side,
the first solar cell (10) and the second solar cell (10B) are arranged in a first direction (X) extending along a width direction of the first solar cell (10A),
the first lower transparent electrode layer (2A), the first power generation layer (G1), and the first upper transparent electrode layer (5A) are stacked in that order from the substrate (1) side,
the second lower transparent electrode layer (2B), the second power generation layer (G2), and the second upper transparent electrode layer (5B) are stacked in that order from the substrate (1) side,
the first metal interconnection wiring (7A) has a portion that extends in a stacking direction of the second upper transparent electrode layer (5B), the second power generation layer (G2), and the second lower transparent electrode layer (2B),
the first lower transparent electrode layer (2A) and the second upper transparent electrode layer (5B) are electrically connected through the first metal interconnection wiring (7A), and
the first metal interconnection wiring (7A) is physically separated from the first upper transparent electrode layer (5A).

2. The solar cell module (100) according to claim 1,
wherein
a portion of the first metal interconnection wiring (7A) that extends in the stacking direction (Y) runs alongside a portion of the second upper transparent electrode layer (5B) and electrically connects the first lower transparent electrode layer (2A) with the second upper transparent electrode layer (5B), or
the portion of the first metal interconnection wiring (7A) that extends in the stacking direction electrically connects the first lower transparent electrode layer (2A) with the second upper transparent electrode layer (5B) through the portion of the first metal interconnection wiring (7A) that extends in the stacking direction (Y).

3. The solar cell module (100) according to claim 1 or 2, wherein
the first metal interconnection wiring (7A) is not physically connected to the first upper transparent electrode layer (5A) and the second lower transparent electrode layer (2B).

4. The solar cell module (100) according to any one of claims 1 to 3, wherein
the first solar cell (10A) and the second solar cell (10B) are electrically connected in series.

5. The solar cell module (100) according to any one of claims 1 to 4, wherein
a width of a single first metal interconnection wiring (7A) is 100 µm or less.

6. The solar cell module (100) according to any one of claims 1 to 5, wherein
a thickness of the first metal interconnection wiring (7A) is 0.1 µm or more.

7. The solar cell module (100) according to any one of claims 1 to 6, wherein
the first metal interconnection wiring (7A) primarily comprises metal and/or alloy.

8. The solar cell module (100) according to any one of claims 1 to 7, wherein
at least 50 wt% of the first metal interconnection wiring (7A) is metal and/or alloy.

9. The solar cell module (100) according to any one of claims 1 to 8, wherein
the first metal interconnection wiring (7A) includes at least one element selected from the group consisting of Al, Au, Ag, Cu, Sc, Ti, V, Cr, Mn, Fe, Co, Ni, Zn, Y, Zr, Nb, Mo, Hf, and Ta.

10. The solar cell module (100) according to any one of claims 1 to 9, wherein
the first power generation layer (G1) comprises a first p-type light-absorbing layer (3A) and a first n-type layer (4A),
the second power generation layer (G2) comprises a second p-type light-absorbing layer (3B) and a second n-type layer (4B), and
both the first p-type light-absorbing layer (3A) and the second p-type light-absorbing layer (3B) include a cuprous oxide compound.

11. The solar cell module (100) according to claim 10, wherein
the first metal interconnection wiring (7A) is in direct contact with the second upper transparent electrode layer (5B) which is in direct contact with the second p-type light-absorbing layer (3B).

12. The solar cell module (100) according to claim 10 or 11, wherein
the first metal interconnection wiring (7A) is in direct contact with the second p-type light-absorbing layer (3B).

13. The solar cell module (100) according to any one of claims 1 to 12, wherein
the second power generation layer (G1) comprises a second p-type light-absorbing layer (3B) and a second n-type layer (4B), and
a distance (D1) between an end surface (S2) of the second lower transparent electrode layer (2B) on the first solar cell (10A side and a side surface (S1) of the second p-type light-absorbing layer (3B) that is in direct contact with the second n-type layer (4B) is three times or more a height (H1) of the second p-type light-absorbing layer (3B).

14. The solar cell module (100) according to claim 13, wherein
the distance (D1) defined in claim 13 is fifteen times the height (H1) of the second p-type light-absorbing layer (3B) or less.

15. A solar cell module (100) comprising:
a substrate (1);
a first solar cell (10A) provided on the substrate (1) and comprising a first upper transparent electrode layer (5A), a first power generation layer (G1), and a first lower transparent electrode layer (2A);
a second solar cell (10B) provided on the substrate (1), adjacent to the first solar cell (10A), the second solar cell (10B) comprising a second upper transparent electrode layer (5B), a second power generation layer (G2), and a second lower transparent electrode layer (2B); and
a first joint section (A1) which electrically connects the first solar cell (10A) and the second solar cell (10B), wherein
the first power generation layer (G1) comprises a first p-type light-absorbing layer (3A) and a first n-type layer (4A),
the second power generation layer (G1) comprises a second p-type light-absorbing layer (3B) and a second n-type layer (4B), and
a distance (D1) between an end side (S2) of the second lower transparent electrode layer (2B) on the first solar cell (10A) side and a side surface (S1) of the second p-type light-absorbing layer (4B) that is in direct contact with the second n-type layer (4B) is three times or more a height (H1) of the second p-type light-absorbing layer (3B).

16. The solar cell module (100) according to claim 15, wherein
the distance (D1) defined in claim 15 is fifteen times the height (H1) of the second p-type light-absorbing layer (3B) or less.

17. The solar cell module (100) according to claim 15 or 16, wherein
the distance (D1) defined in claim 15 is ten times the height (H1)of the second p-type light-absorbing layer (3B) or less, and
the height (H1) of the second p-type light-absorbing layer (3B) is 2 µm or more and 10 µm or less.

18. The solar cell module (100) according to claim 17, wherein
the first junction section (A1) comprises the first metal interconnection wiring (7A), and
the first metal interconnection wiring (7A) runs alongside a portion of the second upper transparent electrode layer (5B) and electrically connects the first lower transparent electrode layer (2A) with the second upper transparent electrode layer (5B).
